# EUROPEAN PATENT APPLICATION

(11) **EP 4 376 084 A1**
(43) Date of publication of application: **29.05.2024**
(21) Application number: 23197767.9
(22) Date of filing: 15.09.2023
(51) Int. Cl.: H01L 27/146

(54) **IMAGE SENSORS**

(30) Priority: 22.11.2022 KR 20220157044
(71) Applicant: Samsung Electronics Co., Ltd., Suwon-si, Gyeonggi-do 16677 (KR)
(72) Inventor: CHOI, Chulsoo, Suwon-si, 16677 (KR); KIM, Bumsuk, Suwon-si, 16677 (KR); LEE, Yun Ki, Suwon-si, 16677 (KR); KIM, Junghun, Suwon-si, 16677 (KR); PARK, Jonghoon, Suwon-si, 16677 (KR)
(74) Representative: Marks & Clerk LLP

(57) **Abstract**

An image sensor includes a substrate having a first surface and a second surface which are opposite to each other, the substrate comprising a plurality of pixel regions arranged in a first direction and a second direction which are parallel to the first surface and intersect each other, a deep device isolation pattern extending into the substrate and between the plurality of pixel regions, and a color separating array on the second surface of the substrate. The color separating array includes a spacer layer on the second surface of the substrate, and a plurality of nano-posts horizontally spaced apart from each other on the spacer layer.

## Description

### BACKGROUND

The present disclosure relates to an image sensor, and more particularly, to an image sensor including a color separating array such as a color separating lens array.

An image sensor is a semiconductor device for converting an optical image into electrical signals. As computer and communication industries have been developed, high-performance image sensors have been increasingly demanded in various fields such as a digital camera, a camcorder, a personal communication system (PCS), a game console, a security camera, and a medical micro camera. Image sensors may be categorized as any one of charge coupled device (CCD) image sensors and complementary metal-oxide-semiconductor (CMOS) image sensors. CIS is short for the CMOS image sensor. The CIS may include a plurality of pixels arranged two-dimensionally. Each of the pixels may include a photodiode (PD). The photodiode may convert incident light into an electrical signal.

Typically, the image sensor may display an image having various colors or sense colors of incident light by using color filters. However, each of the color filters may transmit light of a corresponding color and absorb light of other colors, and thus light utilization efficiency may be reduced. Recently, a method of using a color separating element instead of the color filters has been suggested to improve the light utilization efficiency of the image sensor. The color separating element may be configured to separate different colors of incident light by using diffractive or refractive properties of the color separating element at different wavelengths. The color separating element may, for example, be configured to adjust a direction of the incident light according to a wavelength of the incident light by virtue of a refractive index and shape of the color separating element. The colors separated by the color separating element may travel to corresponding pixels, respectively.

### SUMMARY

Embodiments of the inventive concepts may provide an image sensor capable of improving sensitivity of pixels and inhibiting/minimizing cross-talk between pixels.

Embodiments of the inventive concepts may also provide an image sensor which enables an auto-focus function and which is capable of improving sensitivity of pixels.

In an aspect, an image sensor may include a substrate having a first surface and a second surface which are opposite to each other, the substrate comprising a plurality of pixel regions arranged in a first direction and a second direction which are parallel to the first surface and intersect each other (e.g. wherein the first and second directions are different from one another and, optionally, wherein the first and second directions are perpendicular to one another), a deep device isolation pattern extending into the substrate and between the plurality of pixel regions, and a color separating array such as a color separating lens array on the second surface of the substrate. The color separating array may include a spacer layer on the second surface of the substrate, and a plurality of nano-posts horizontally spaced apart from each other on the spacer layer. For example, the plurality of nano-posts may be spaced apart from each other on the spacer layer in one or more directions parallel to the first surface.

In an aspect, an image sensor may include a substrate having a first surface and a second surface which are opposite to each other, the substrate comprising a plurality of pixel regions arranged in a first direction and a second direction which are parallel to the first surface and intersect each other (e.g. wherein the first and second directions are different from one another and, optionally, wherein the first and second directions are perpendicular to one another), a deep device isolation pattern extending into the substrate and between the plurality of pixel regions, and a color separating array such as a color separating lens array on the second surface of the substrate. The color separating array may include a plurality of nano-posts horizontally spaced apart from each other on the second surface of the substrate. Each of the plurality of pixel regions may include a first photoelectric conversion region and a second photoelectric conversion region which are adjacent to each other in the first direction. The deep device isolation pattern may include an extension extending into each of the plurality of pixel regions in the second direction to be between the first photoelectric conversion region and the second photoelectric conversion region.

According to some embodiments, an image sensor may include a substrate including first and second pixel regions. The image sensor may include a device isolation region between the first and second pixel regions. Moreover, the image sensor may include a color-separating array comprising a plurality of nano-structures that are spaced apart from each other. The color-separating array may be configured to separate incident light into first light that has a first wavelength and is irradiated to the first pixel region and second light that has a second wavelength and is irradiated to the second pixel region. The second wavelength may be different from the first wavelength.

At least some of the above and other features of the invention are set out in the claims.

### BRIEF DESCRIPTION OF THE DRAWINGS

The above and other aspects will become more apparent from the following description of example embodiments with reference to the accompanying drawings, in which
FIG. 1 is a block diagram schematically illustrating an image sensor according to some embodiments of the inventive concepts.
FIG. 2 is a circuit diagram illustrating a unit pixel of an image sensor according to some embodiments of the inventive concepts.
FIG. 3 is a plan view illustrating an image sensor according to some embodiments of the inventive concepts.
FIG. 4 is a cross-sectional view taken along a line I-I' of FIG. 3.
FIG. 5 is an enlarged view of a portion 'P1' of FIG. 4.
FIGS. 6 to 13 are plan views illustrating image sensors according to some embodiments of the inventive concepts.
FIG. 14 is a circuit diagram illustrating a unit pixel of an image sensor according to some embodiments of the inventive concepts.
FIG. 15 is a plan view illustrating an image sensor according to some embodiments of the inventive concepts.
FIG. 16 is a cross-sectional view taken along a line I-I' of FIG. 15.
FIGS. 17 and 18 are plan views illustrating image sensors according to some embodiments of the inventive concepts.
FIGS. 19 to 21 are cross-sectional views corresponding to the line I-I' of FIG. 3 to illustrate a method of manufacturing an image sensor according to some embodiments of the inventive concepts.
FIG. 22 is a plan view illustrating an image sensor according to some embodiments of the inventive concepts.
FIG. 23 is a cross-sectional view taken along a line II-II' of FIG. 22.
FIG. 24 is a cross-sectional view illustrating an image sensor according to some embodiments of the inventive concepts.

### DETAILED DESCRIPTION

Embodiments of the inventive concepts will now be described more fully with reference to the accompanying drawings.

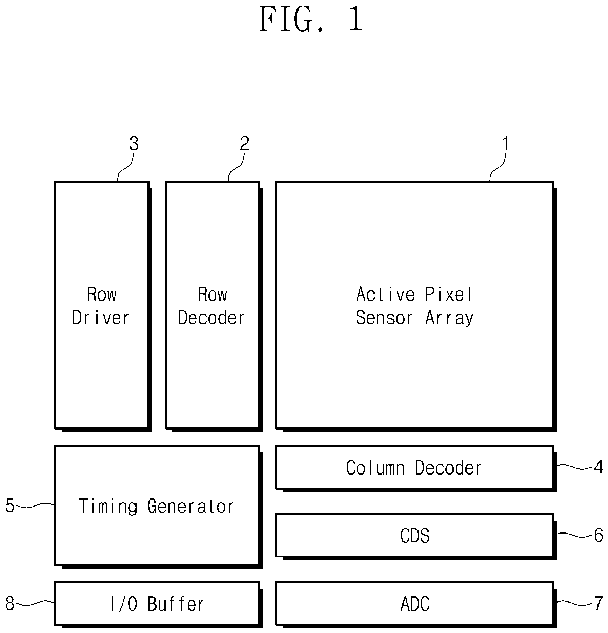

FIG. 1 is a block diagram schematically illustrating an image sensor according to some embodiments of the inventive concepts.

Referring to FIG. 1, an image sensor may include an active pixel sensor array 1, a row decoder 2, a row driver 3, a column decoder 4, a timing generator 5, a correlated double sampler (CDS) 6, an analog-to-digital converter (ADC) 7, and an input/output (I/O) buffer 8.

The active pixel sensor array 1 may include a plurality of pixels arranged two-dimensionally and may convert optical signals into electrical signals. The active pixel sensor array 1 may be driven by a plurality of driving signals (e.g., a pixel selection signal, a reset signal, and a charge transfer signal) provided from the row driver 3. In addition, the electrical signals converted by the active pixel sensor array 1 may be provided to the correlated double sampler 6.

The row driver 3 may provide the plurality of driving signals for driving the plurality of pixels to the active pixel sensor array 1 in response to signals decoded in the row decoder 2. When the pixels are arranged in a matrix form, the driving signals may be provided in the unit of row of the matrix form.

The timing generator 5 may provide timing signals and control signals to the row decoder 2 and the column decoder 4.

The correlated double sampler (CDS) 6 may receive electrical signals generated from the active pixel sensor array 1 and may hold and sample the received electrical signals. The correlated double sampler 6 may doubly sample a specific noise level and a signal level of the electrical signal and may output a difference level corresponding to a difference between the noise level and the signal level.

The analog-to-digital converter (ADC) 7 may convert an analog signal, which corresponds to the difference level outputted from the correlated double sampler 6, into a digital signal and may output the digital signal.

The I/O buffer 8 may latch the digital signals and may sequentially output the latched signals to an image signal processing unit (not shown) in response to signals decoded in the column decoder 4.

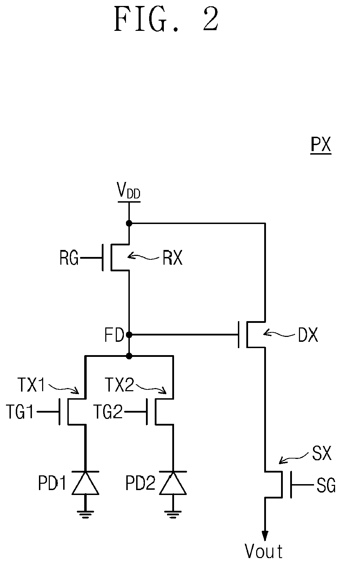

FIG. 2 is a circuit diagram illustrating a unit pixel of an image sensor according to some embodiments of the inventive concepts.

Referring to FIGS. 1 and 2, the active pixel sensor array 1 may include the plurality of pixels PX, and the pixels PX may be arranged in a matrix form. Each of the pixels PX may include a first photoelectric conversion element PD1, a second photoelectric conversion element PD2, a first transfer transistor TX1, a second transfer transistor TX2, and logic transistors RX, SX and DX. The logic transistors RX, SX and DX may include a reset transistor RX, a selection transistor SX, and a drive transistor DX. The first transfer transistor TX1, the second transfer transistor TX2, the reset transistor RX and the selection transistor SX may include a first transfer gate TG1, a second transfer gate TG2, a reset gate RG and a selection gate SG, respectively. Each of the pixels PX may further include a floating diffusion region FD.

The first and second photoelectric conversion elements PD1 and PD2 may generate and accumulate photocharges in proportion to the amount of light incident on the first and second photoelectric conversion elements PD1 and PD2 respectively. Each of the first and second photoelectric conversion elements PD1 and PD2 may be a photodiode including a P-type dopant region and an N-type dopant region. The first transfer transistor TX1 may transfer charges (or photocharges) generated from the first photoelectric conversion element PD1 to the floating diffusion region FD, and the second transfer transistor TX2 may transfer charges generated from the second photoelectric conversion element PD2 to the floating diffusion region FD.

The floating diffusion region FD may receive the charges generated from the first and second photoelectric conversion elements PD1 and PD2 and may cumulatively store the received charges. The drive transistor DX may be controlled according to the amount of the charges accumulated in the floating diffusion region FD.

The reset transistor RX may periodically reset the charges accumulated in the floating diffusion region FD. A drain electrode of the reset transistor RX may be connected to the floating diffusion region FD, and a source electrode of the reset transistor RX may be connected to a power voltage V_{DD}. When the reset transistor RX is turned-on, the power voltage V_{DD} connected to the source electrode of the reset transistor RX may be applied to the floating diffusion region FD. Thus, when the reset transistor RX is turned-on, the charges accumulated in the floating diffusion region FD may be discharged to reset the floating diffusion region FD.

The drive transistor DX may function as a source follower buffer amplifier. The drive transistor DX may amplify a potential change in the floating diffusion region FD and may output the amplified potential change to an output line Vout.

The selection transistor SX may select the pixels PX to be read in the unit of row. When the selection transistor SX is turned-on, the power voltage V_{DD} may be applied to a drain electrode of the drive transistor DX.

The unit pixel PX including two photoelectric conversion elements PD1 and PD2 and five transistors TX1, TX2, RX, DX and SX is illustrated as an example in FIG. 2, but embodiments of the inventive concepts are not limited thereto. In certain embodiments, the reset transistor RX, the drive transistor DX or the selection transistor SX may be shared by adjacent pixels PX. Thus, an integration density of the image sensor may be improved.

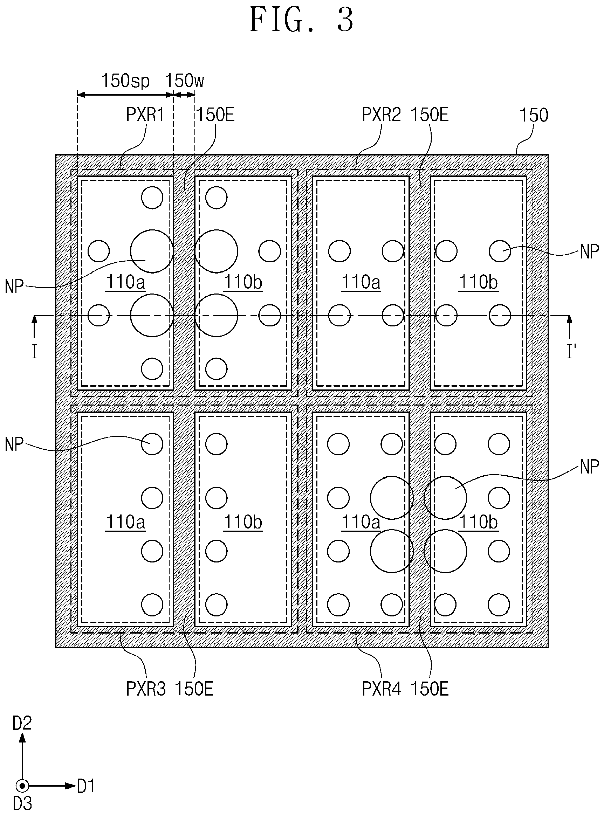

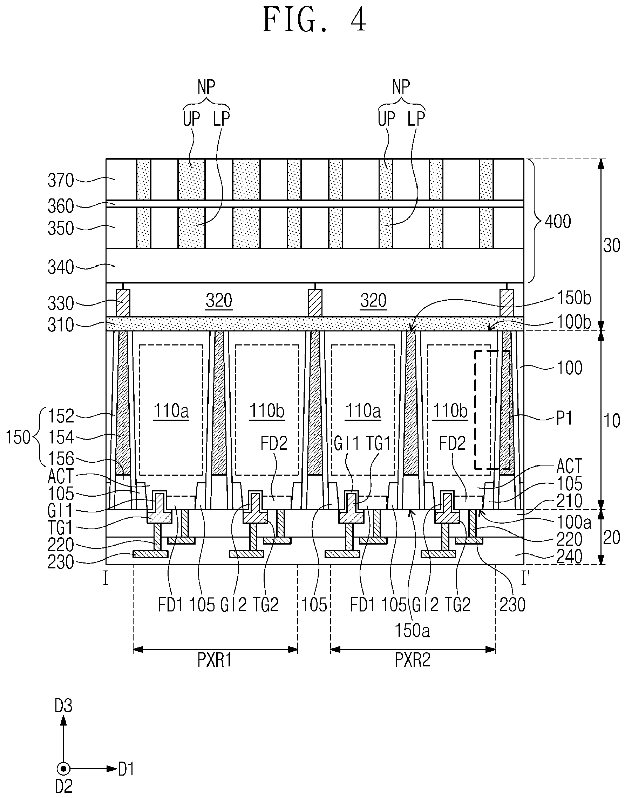

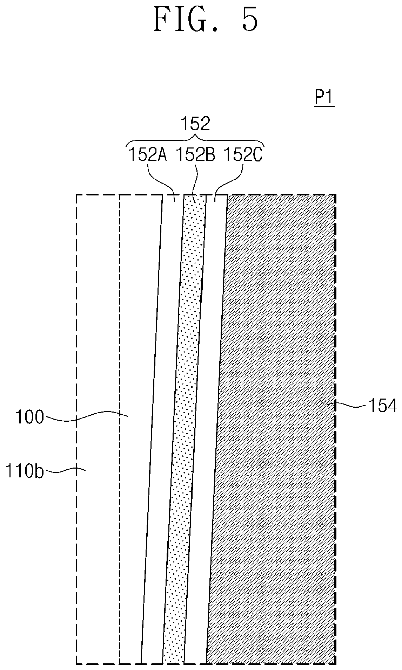

FIG. 3 is a plan view illustrating an image sensor according to some embodiments of the inventive concepts, and FIG. 4 is a cross-sectional view taken along a line I-I' of FIG. 3. FIG. 5 is an enlarged view of a portion 'P1' of FIG. 4.

Referring to FIGS. 3 and 4, an image sensor may include a photoelectric conversion layer 10, an interconnection layer 20, and a light transmitting layer 30. The photoelectric conversion layer 10 may be disposed between, in a third direction D3, the interconnection layer 20 and the light transmitting layer 30.

The photoelectric conversion layer 10 may include a substrate 100, and the substrate 100 may include a plurality of pixel regions PXR1, PXR2, PXR3 and PXR4. The substrate 100 may be a semiconductor substrate (e.g., a silicon substrate, a germanium substrate, a silicon-germanium substrate, a group II-VI compound semiconductor substrate, or a group III-V compound semiconductor substrate) or a silicon-on-insulator (SOI) substrate. The substrate 100 may have a first surface 100a and a second surface 100b, which are opposite to each other. The plurality of pixel regions PXR1, PXR2, PXR3 and PXR4 may be two-dimensionally arranged in a first direction D1 and a second direction D2 which are parallel to the first surface 100a of the substrate 100. The first direction D1 and the second direction D2 may intersect each other e.g. the first direction D1 and the second direction D2 may be perpendicular to one another.

For example, the plurality of pixel regions PXR1, PXR2, PXR3 and PXR4 may include a first pixel region PXR1 and a second pixel region PXR2 which are adjacent to each other in the first direction D1, a third pixel region PXR3 adjacent to the first pixel region PXR1 in the second direction D2, and a fourth pixel region PXR4 adjacent to the second pixel region PXR2 in the second direction D2. The third pixel region PXR3 and the fourth pixel region PXR4 may be adjacent to each other in the first direction D1. The second pixel region PXR2 and the third pixel region PXR3 may be configured to sense light of the same wavelength. The first pixel region PXR1 may be configured to sense light of a wavelength different from that of the light sensed by the second and third pixel regions PXR2 and PXR3. The fourth pixel region PXR4 may be configured to sense light of a wavelength different from those of the light sensed by the first to third pixel regions PXR1, PXR2 and PXR3. For example, the first pixel region PXR1 may be configured to sense red light, the second and third pixel regions PXR2 and PXR3 may be configured to sense green light, and the fourth pixel region PXR4 may be configured to sense blue light.

The photoelectric conversion layer 10 may further include a deep device isolation pattern 150 which penetrates the substrate 100 and is disposed between the plurality of pixel regions PXR1, PXR2, PXR3 and PXR4. The deep device isolation pattern 150 may penetrate the substrate 100 in a third direction D3 perpendicular to the first surface 100a of the substrate 100. The deep device isolation pattern 150 may extend from the first surface 100a of the substrate 100 toward the second surface 100b of the substrate 100. The first surface 100a of the substrate 100 may expose (e.g., may not overlap, in the third direction D3) a third surface 150a of the deep device isolation pattern 150, and the second surface 100b of the substrate 100 may expose (e.g., may not overlap, in the third direction D3) a fourth surface 150b of the deep device isolation pattern 150. The third surface 150a and the fourth surface 150b of the deep device isolation pattern 150 may be opposite to each other in the third direction D3. The third surface 150a of the deep device isolation pattern 150 may be substantially coplanar with the first surface 100a of the substrate 100, and the fourth surface 150b of the deep device isolation pattern 150 may be substantially coplanar with the second surface 100b of the substrate 100. The deep device isolation pattern 150 may inhibit/prevent cross-talk between the plurality of pixel regions PXR1, PXR2, PXR3 and PXR4.

The deep device isolation pattern 150 may surround each of the plurality of pixel regions PXR1, PXR2, PXR3 and PXR4 when viewed in a plan view. The deep device isolation pattern 150 may extend in the first direction D1 and the second direction D2 to surround each of the plurality of pixel regions PXR1, PXR2, PXR3 and PXR4. The deep device isolation pattern 150 may include an extension 150E extending into each of the plurality of pixel regions PXR1, PXR2, PXR3 and PXR4 in the second direction D2. In some embodiments, the extension 150E of the deep device isolation pattern 150 may extend from a portion of the deep device isolation pattern 150 in the second direction D2 so as to be connected to another portion of the deep device isolation pattern 150.

The deep device isolation pattern 150 may include a semiconductor pattern 154 penetrating at least a portion of the substrate 100, a filling insulation pattern 156 on the semiconductor pattern 154, and a side insulating pattern 152 disposed between the semiconductor pattern 154 and the substrate 100. The side insulating pattern 152 may extend from a side surface of the semiconductor pattern 154 onto a side surface of the filling insulation pattern 156. The semiconductor pattern 154 may include a semiconductor material doped with dopants. The dopants may have a P-type or an N-type. For example, the semiconductor pattern 154 may include poly-silicon doped with boron. For example, the filling insulation pattern 156 may include silicon oxide, silicon nitride, and/or silicon oxynitride. In some embodiments, the side insulating pattern 152 may be a single layer including an insulating material (e.g., silicon oxide, silicon nitride, and/or silicon oxynitride).

Referring to FIGS. 4 and 5, in certain embodiments, the side insulating pattern 152 may have a multi-layered structure including a first pattern 152A, a second pattern 152B and a third pattern 152C which are sequentially stacked between the substrate 100 and the semiconductor pattern 154. The first pattern 152A may be disposed adjacent to the substrate 100, the third pattern 152C may be disposed adjacent to the semiconductor pattern 154, and the second pattern 152B may be disposed between the first pattern 152A and the third pattern 152C. Each of the first to third patterns 152A, 152B and 152C may extend from the side surface of the semiconductor pattern 154 onto the side surface of the filling insulation pattern 156. For example, each of the first pattern 152A and the third pattern 152C may include silicon oxide, and the second pattern 152B may include silicon nitride. For certain examples, each of the first pattern 152A and the third pattern 152C may include silicon oxide, and the second pattern 152B may include a semiconductor material (e.g., poly-silicon).

Referring again to FIGS. 3 and 4, in certain embodiments, the deep device isolation pattern 150 may be a single pattern including an insulating material (e.g., silicon oxide, silicon nitride, and/or silicon oxynitride), unlike what is shown in FIGS. 3 and 4.

A first photoelectric conversion region 110a and a second photoelectric conversion region 110b may be disposed in each of the plurality of pixel regions PXR1, PXR2, PXR3 and PXR4 and may be adjacent to each other in the first direction D1 in each of the pixel regions PXR1, PXR2, PXR3 and PXR4. The extension 150E of the deep device isolation pattern 150 may extend into each of the pixel regions PXR1, PXR2, PXR3 and PXR4 in the second direction D2 and may be disposed between the first photoelectric conversion region 110a and the second photoelectric conversion region 110b. In some embodiments, the extension 150E of the deep device isolation pattern 150 may completely isolate the first photoelectric conversion region 110a and the second photoelectric conversion region 110b from each other in each of the pixel regions PXR1, PXR2, PXR3 and PXR4.

The substrate 100 may have a first conductivity type, and the first and second photoelectric conversion regions 110a and 110b may be regions doped with dopants having a second conductivity type different from the first conductivity type. For example, the first conductivity type and the second conductivity type may be a P-type and an N-type, respectively. In this case, the dopants having the second conductivity type may include N-type dopants such as phosphorus, arsenic, bismuth, and/or antimony. Each of the first and second photoelectric conversion regions 110a and 110b may form a PN junction with the substrate 100 to form a photodiode. For example, the first photoelectric conversion region 110a may form the PN junction with the substrate 100 to form a first photodiode (see PD1 of FIG. 2), and the second photoelectric conversion region 110b may form the PN junction with the substrate 100 to form a second photodiode (see PD2 of FIG. 2). Each of the pixel regions PXR1, PXR2, PXR3 and PXR4 may correspond to the unit pixel (see PX of FIG. 2) including the first photodiode (see PD1 of FIG. 2) and the second photodiode (see PD2 of FIG. 2). In some embodiments, the semiconductor pattern 154 of the deep device isolation pattern 150 may include a semiconductor material doped with dopants having the first conductivity type (e.g., P-type dopants).

A shallow device isolation pattern 105 may be disposed adjacent to the first surface 100a of the substrate 100. Each of the plurality of pixel regions PXR1, PXR2, PXR3 and PXR4 may include an active pattern ACT defined by the shallow device isolation pattern 105. For example, the shallow device isolation pattern 105 may include at least one of a silicon oxide layer, a silicon nitride layer, or a silicon oxynitride layer. The deep device isolation pattern 150 may penetrate the shallow device isolation pattern 105 and may extend into the substrate 100. A portion of the active pattern ACT may vertically overlap with the first photoelectric conversion region 110a (e.g., in the third direction D3), and another portion of the active pattern ACT may vertically overlap with the second photoelectric conversion region 110b (e.g., in the third direction D3).

The filling insulation pattern 156 of the deep device isolation pattern 150 may be disposed in the shallow device isolation pattern 105. The filling insulation pattern 156 may penetrate the shallow device isolation pattern 105 so as to be in contact with the semiconductor pattern 154. The side insulating pattern 152 of the deep device isolation pattern 150 may extend between the shallow device isolation pattern 105 and the filling insulation pattern 156.

A first transfer gate electrode TG1, a first floating diffusion region FD1, a second transfer gate electrode TG2 and a second floating diffusion region FD2 may be disposed on each of the pixel regions PXR1, PXR2, PXR3 and PXR4 and may be disposed adjacent to the first surface 100a of the substrate 100. The first transfer gate electrode TG1 and the first floating diffusion region FD1 may be disposed on the portion of the active pattern ACT and may vertically overlap with the first photoelectric conversion region 110a (e.g., in the third direction D3). The second transfer gate electrode TG2 and the second floating diffusion region FD2 may be disposed on the other portion of the active pattern ACT and may vertically overlap with the second photoelectric conversion region 110b (e.g., in the third direction D3).

A lower portion of the first transfer gate electrode TG1 may extend into the substrate 100 toward the first photoelectric conversion region 110a, and an upper portion of the first transfer gate electrode TG1 may protrude above a top surface of the active pattern ACT (i.e., the first surface 100a of the substrate 100). A lower portion of the second transfer gate electrode TG2 may extend into the substrate 100 toward the second photoelectric conversion region 110b, and an upper portion of the second transfer gate electrode TG2 may protrude above the top surface of the active pattern ACT (i.e., the first surface 100a of the substrate 100). The first floating diffusion region FD1 and the second floating diffusion region FD2 may be regions doped with dopants (e.g., N-type dopants) having the second conductivity type different from the first conductivity type of the substrate 100.

The first transfer gate electrode TG1 and the first floating diffusion region FD1 may constitute the first transfer transistor TX1 of FIG. 2. The second transfer gate electrode TG2 and the second floating diffusion region FD2 may constitute the second transfer transistor TX2 of FIG. 2.

A first gate dielectric pattern GI1 may be disposed between the first transfer gate electrode TG1 and the substrate 100 (i.e., the active pattern ACT), and a second gate dielectric pattern GI2 may be disposed between the second transfer gate electrode TG2 and the substrate 100 (i.e., the active pattern ACT).

The interconnection layer 20 may be disposed on the first surface 100a of the substrate 100. The interconnection layer 20 may include a first interlayer insulating layer 210 and a second interlayer insulating layer 240, which are sequentially stacked on the first surface 100a of the substrate 100. The first interlayer insulating layer 210 may be disposed on the first surface 100a of the substrate 100 to cover the first and second transfer gate electrodes TG1 and TG2. The interconnection layer 20 may further include contact plugs 220 connected to the first and second transfer gate electrodes TG1 and TG2 and the first and second floating diffusion regions FD1 and FD2, and conductive lines 230 connected to the contact plugs 220. The contact plugs 220 may penetrate the first interlayer insulating layer 210 so as to be electrically connected to the first and second transfer gate electrodes TG1 and TG2 and the first and second floating diffusion regions FD1 and FD2. The conductive lines 230 may be disposed in the second interlayer insulating layer 240. At least some of the contact plugs 220 may extend into the second interlayer insulating layer 240 so as to be connected (e.g., electrically connected) to the conductive lines 230. The first interlayer insulating layer 210 and the second interlayer insulating layer 240 may include an insulating material, and the contact plugs 220 and the conductive lines 230 may include a conductive material.

The light transmitting layer 30 may be disposed on the second surface 100b of the substrate 100. The light transmitting layer 30 may include a color separating lens array 400 disposed on the second surface 100b of the substrate 100. The color separating lens array 400 may vertically overlap with the substrate 100 and the deep device isolation pattern 150 in the third direction D3.

The color separating lens array 400 may include a spacer layer 340 on the second surface 100b of the substrate 100, and a plurality of nano-posts (or other nano-structures) NP horizontally spaced apart from each other (e.g., spaced apart from each other in the first direction D1 and/or the second direction D2 or in any arbitrary direction parallel to the first surface 100a of the substrate 100) on the spacer layer 340. In some embodiments, the nano-posts NP may be used instead of micro-lenses (and thus may not be micro-lenses). Each of the plurality of nano-posts NP may have a pillar (or post) shape extending from the spacer layer 340 in the third direction D3. Each of the plurality of nano-posts NP may have a nanoscale dimension (e.g. a dimension from 0.1 to 100 nm) in a horizontal direction (e.g., in the first direction D1 or the second direction D2 or in any arbitrary direction parallel to the first surface 100a of the substrate 100). Each nano-post NP may have a flat surface which is parallel to the first surface 100a of the substrate 100. The color separating lens array 400 may divide incident light into lights (e.g., first light and second light) having different wavelengths and may be configured to allow the lights having different wavelengths to be irradiated to different ones of the plurality of pixel regions PXR1, PXR2, PXR3 and PXR4. For example, the color separating lens array 400 may be configured to allow first wavelength light (e.g., red light) of the incident light to be irradiated to the first pixel region PXR1, to allow second wavelength light (e.g., green light) of the incident light to be irradiated to the second and third pixel regions PXR2 and PXR3, and to allow third wavelength light (e.g., blue light) of the incident light to be irradiated to the fourth pixel region PXR4.

According to some embodiments, each nano-post NP of the plurality of nano-posts NP may include a lower post LP and an upper post UP, which are vertically spaced apart from each other (e.g., in the third direction D3). The plurality of lower posts LP may be provided on the spacer layer 340, and the plurality of lower posts LP may be horizontally spaced apart from each other (e.g., in the first direction D1 and/or the second direction D2 or in any arbitrary direction parallel to the first surface 100a of the substrate 100) on the spacer layer 340. The color separating lens array 400 may further include a lower dielectric layer 350 in (e.g., filling) a space between the lower posts LP on the spacer layer 340. The plurality of upper posts UP may be horizontally spaced apart from each other (e.g., in the first direction D1 and/or the second direction D2 or in any arbitrary direction parallel to the first surface 100a of the substrate 100). The plurality of upper posts UP may be aligned with the plurality of lower posts LP, respectively, and may vertically overlap with the plurality of lower posts LP (e.g., in the third direction D3), respectively. The color separating lens array 400 may further include an upper dielectric layer 370 in (e.g., filling) a space between the plurality of upper posts UP on the lower dielectric layer 350. The color separating lens array 400 may further include an etch stop layer 360 disposed between the lower dielectric layer 350 and the upper dielectric layer 370 and between the plurality of lower posts LP and the plurality of upper posts UP. Alternatively, the plurality of upper posts UP may be provided directly on the lower dielectric layer 350 (i.e. the etch stop layer 360 may be omitted), wherein the plurality of upper posts UP are horizontally spaced apart from each other (e.g., in the first direction D1 and/or the second direction D2 or in any arbitrary direction parallel to the first surface 100a of the substrate 100) on the lower dielectric layer 350.

The plurality of nano-posts NP may include a material having a refractive index which is higher than those of the spacer layer 340, the lower dielectric layer 350 and the upper dielectric layer 370. When comparing different refractive indices, the same wavelength of light (e.g. visible light) may be utilized. For example, the plurality of nano-posts NP may include at least one of crystalline silicon, poly-silicon, amorphous silicon, a group III-V compound semiconductor material (e.g., GaP, GaN, GaAs, etc.), SiC, TiO₂, or SiN. The spacer layer 340 may include a material having a refractive index lower than that of the plurality of nano-posts NP and may include at least one of, for example, glass (e.g., fused silica, BK7, etc.), quartz, a polymer material (e.g., PMMA, SU-8, etc.), or plastic. The lower dielectric layer 350 and the upper dielectric layer 370 may include a dielectric material having a refractive index lower than that of the plurality of nano-posts NP. For example, the etch stop layer 360 may include aluminum oxide.

The light transmitting layer 30 may further include an anti-reflection layer 310 between the second surface 100b of the substrate 100 and the color separating lens array 400, and a color filter array 320 between the anti-reflection layer 310 and the color separating lens array 400. The color filter array 320 may include a plurality of color filters 320 disposed on the plurality of pixel regions PXR1, PXR2, PXR3 and PXR4, respectively. Each of the plurality of color filters 320 may vertically overlap with the first and second photoelectric conversion regions 110a and 110b of each of the plurality of pixel regions PXR1, PXR2, PXR3 and PXR4 (e.g., in the third direction D3). The anti-reflection layer 310 may be disposed between the second surface 100b of the substrate 100 and the color filter array 320. The anti-reflection layer 310 may inhibit/prevent reflection of light incident on the second surface 100b of the substrate 100 to allow the light to reach the first and second photoelectric conversion regions 110a and 110b with little or no loss. The light transmitting layer 30 may further include a grid 330 disposed between the plurality of color filters 320. The grid 330 may guide light incident on the second surface 100b of the substrate 100 to allow the light to be incident on the first and second photoelectric conversion regions 110a and 110b. For example, the grid 330 may include a metal.

In each of the plurality of pixel regions PXR1, PXR2, PXR3 and PXR4, a width 150w of the deep device isolation pattern 150 in the first direction D1 may range from 0.01 times to 0.2 times a distance 150sp between portions of the deep device isolation pattern 150, which are immediately adjacent to each other in the first direction D1.

According to the inventive concepts, the image sensor may include the color separating lens array 400, and the color separating lens array 400 may be configured to separate wavelengths of incident light from each other and may be configured to allow lights having different wavelengths to be irradiated to different pixel regions PXR1, PXR2, PXR3 and PXR4. Thus, light efficiency of the incident light may be maximized, and sensitivity of the pixel regions PXR1, PXR2, PXR3 and PXR4 may be improved. In addition, the image sensor may further include the deep device isolation pattern 150 disposed between the pixel regions PXR1, PXR2, PXR3 and PXR4. Thus, cross-talk between the pixel regions PXR1, PXR2, PXR3 and PXR4 may be inhibited/minimized. The deep device isolation pattern 150 may include the extension 150E extending into each of the pixel regions PXR1, PXR2, PXR3 and PXR4, and the extension 150E of the deep device isolation pattern 150 may be disposed between the first photoelectric conversion region 110a and the second photoelectric conversion region 110b. As a result, it is possible to inhibit/minimize interference between light incident on the first photoelectric conversion region 110a and light incident on the second photoelectric conversion region 110b in each of the pixel regions PXR1, PXR2, PXR3 and PXR4, and thus each of the pixel regions PXR1, PXR2, PXR3 and PXR4 may function as an auto-focus pixel.

As a result, it is possible to provide an image sensor which has the auto-focus function and is capable of improving the sensitivity of the pixel and of inhibiting/minimizing the cross-talk between the pixels.

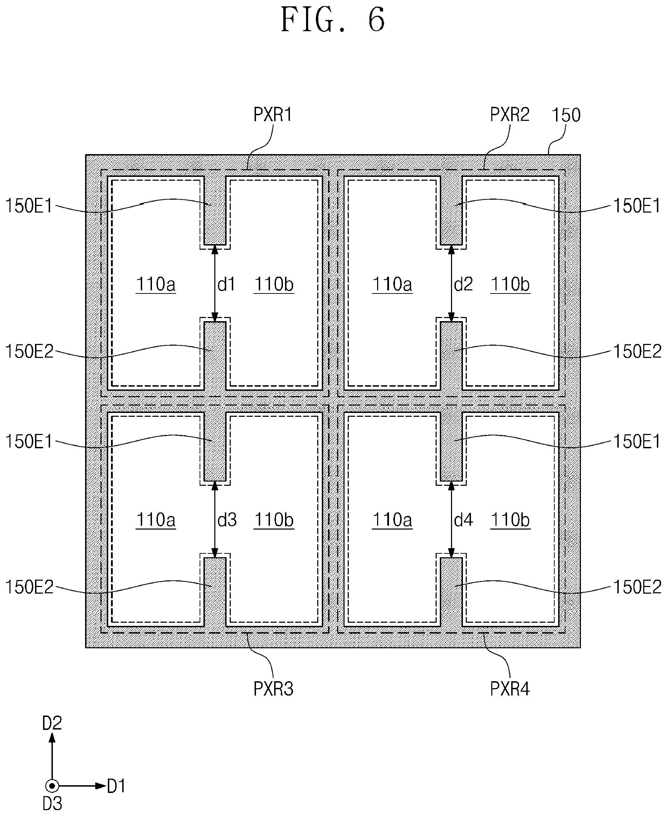

FIGS. 6 to 13 are plan views illustrating image sensors according to some embodiments of the inventive concepts. In FIGS. 6 to 13, the nano-posts NP of FIG. 3 are omitted for the purpose of ease and convenience in illustration. Hereinafter, differences between the present embodiments and the above embodiments of FIGS. 3 to 5 will be mainly described for the purpose of ease and convenience in explanation.

Referring to FIG. 6, the deep device isolation pattern 150 may include an extension 150E1 and 150E2 extending into each of the plurality of pixel regions PXR1, PXR2, PXR3 and PXR4 in the second direction D2. In some embodiments, the extension 150E1 and 150E2 of the deep device isolation pattern 150 may include a first extension 150E1 and a second extension 150E2, which are spaced apart from each other in the second direction D2. The first extension 150E1 may extend from a portion of the deep device isolation pattern 150 into each of the plurality of pixel regions PXR1, PXR2, PXR3 and PXR4 in an opposite direction to the second direction D2, and the second extension 150E2 may extend from another portion of the deep device isolation pattern 150 into each of the plurality of pixel regions PXR1, PXR2, PXR3 and PXR4 in the second direction D2. The first extension 150E1 and the second extension 150E2 in the first pixel region PXR1 may be spaced apart from each other in the second direction D2 by a first distance d1, and the first extension 150E1 and the second extension 150E2 in the second pixel region PXR2 may be spaced apart from each other in the second direction D2 by a second distance d2. The first extension 150E1 and the second extension 150E2 in the third pixel region PXR3 may be spaced apart from each other in the second direction D2 by a third distance d3, and the first extension 150E1 and the second extension 150E2 in the fourth pixel region PXR4 may be spaced apart from each other in the second direction D2 by a fourth distance d4. In some embodiments, the first to fourth distances d1, d2, d3 and d4 may be equal to each other. In certain embodiments, at least one of the first to fourth distances d1, d2, d3 and d4 may be different from the other(s) of the first to fourth distances d1, d2, d3 and d4.

The first photoelectric conversion region 110a and the second photoelectric conversion region 110b may be disposed in each of the plurality of pixel regions PXR1, PXR2, PXR3 and PXR4 and may be adjacent to each other in the first direction D1 in each of the pixel regions PXR1, PXR2, PXR3 and PXR4. In some embodiments, the first photoelectric conversion region 110a and the second photoelectric conversion region 110b may extend between the first and second extensions 150E1 and 150E2 of the deep device isolation pattern 150 so as to be connected to each other.

Except for the differences described above, other components and features of the image sensor according to the present embodiments may be substantially the same as corresponding components and features of the image sensor described with reference to FIGS. 3 to 5.

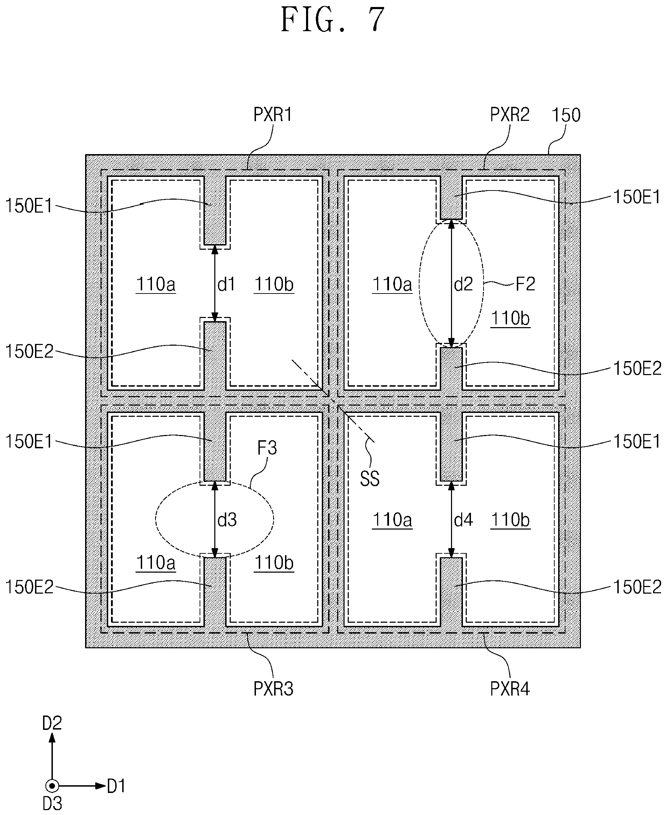

Referring to FIGS. 4 and 7, the second pixel region PXR2 and the third pixel region PXR3 may be configured to sense light of the same wavelength. In the image sensor including the color separating lens array 400, a distribution of an electric field F2 in a focal plane of the second pixel region PXR2 may be different from a distribution of an electric field F3 in a focal plane of the third pixel region PXR3. The focal plane may be adjacent to the second surface 100b of the substrate 100. For example, the second pixel region PXR2 and the third pixel region PXR3 may be configured to sense green light, and the distribution of the electric field F2 in the focal plane of the second pixel region PXR2 and the distribution of the electric field F3 in the focal plane of the third pixel region PXR3 may be substantially symmetrical with respect to a reference line SS. For example, the distribution of the electric field F2 in the focal plane of the second pixel region PXR2 may be elongated in the second direction D2, and the distribution of the electric field F3 in the focal plane of the third pixel region PXR3 may be elongated in the first direction D1. The reference line SS may be a line corresponding to Y=-X in a graph using the first direction D1 as an X-axis and using the second direction D2 as a Y-axis. In this case, a signal difference between the second pixel region PXR2 and the third pixel region PXR3 may be generated due to a difference between overlapping areas of the electric fields F2 and F3 and the extensions 150E1 and 150E2 of the deep device isolation pattern 150 in the second and third pixel regions PXR2 and PXR3.

In some embodiments, the second distance d2 between the first extension 150E1 and the second extension 150E2 of the deep device isolation pattern 150 in the second pixel region PXR2 may be different from the third distance d3 between the first extension 150E1 and the second extension 150E2 of the deep device isolation pattern 150 in the third pixel region PXR3. In the second and third pixel regions PXR2 and PXR3, the second distance d2 and the third distance d3 may be adjusted in such a way that the overlapping areas of the electric fields F2 and F3 and the extensions 150E1 and 150E2 of the deep device isolation pattern 150 are substantially equal to each other. For example, the second distance d2 may be greater than the third distance d3. Thus, the signal difference between the second pixel region PXR2 and the third pixel region PXR3 may be reduced/minimized.

Except for the differences described above, other components and features of the image sensor according to the present embodiments may be substantially the same as corresponding components and features of the image sensor described with reference to FIG. 6.

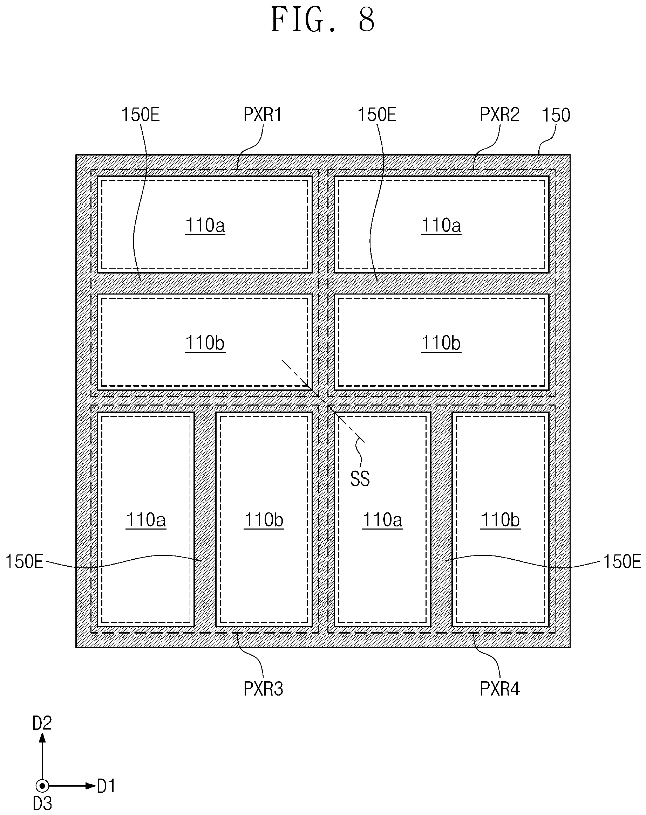

Referring to FIG. 8, according to some embodiments, the deep device isolation pattern 150 may include an extension 150E extending into each of the plurality of pixel regions PXR1, PXR2, PXR3 and PXR4 in the first direction D1 or the second direction D2. For example, the extension 150E of the deep device isolation pattern 150 may extend into each of the first and second pixel regions PXR1 and PXR2 in the first direction D1 and may extend into each of the third and fourth pixel regions PXR3 and PXR4 in the second direction D2. The extension 150E of the deep device isolation pattern 150 may extend from a portion of the deep device isolation pattern 150 in the first direction D1 or the second direction D2 so as to be connected to another portion of the deep device isolation pattern 150.

In each of the first and second pixel regions PXR1 and PXR2, the first photoelectric conversion region 110a and the second photoelectric conversion region 110b may be adjacent to each other in the second direction D2. In each of the first and second pixel regions PXR1 and PXR2, the extension 150E of the deep device isolation pattern 150 may extend in the first direction D1 so as to be disposed between the first photoelectric conversion region 110a and the second photoelectric conversion region 110b and may completely isolate the first photoelectric conversion region 110a and the second photoelectric conversion region 110b from each other. In each of the third and fourth pixel regions PXR3 and PXR4, the first photoelectric conversion region 110a and the second photoelectric conversion region 110b may be adjacent to each other in the first direction D1. In each of the third and fourth pixel regions PXR3 and PXR4, the extension 150E of the deep device isolation pattern 150 may extend in the second direction D2 so as to be disposed between the first photoelectric conversion region 110a and the second photoelectric conversion region 110b and may completely isolate the first photoelectric conversion region 110a and the second photoelectric conversion region 110b from each other.

According to the present embodiments, the extension 150E of the deep device isolation pattern 150 in the second pixel region PXR2 and the extension 150E of the deep device isolation pattern 150 in the third pixel region PXR3 may be symmetrical with respect to the reference line SS. In this case, in the second and third pixel regions PXR2 and PXR3, overlapping areas of the electric fields F2 and F3 of FIG. 7 and the extensions 150E of the deep device isolation pattern 150 may be substantially equal to each other. Thus, a signal difference between the second pixel region PXR2 and the third pixel region PXR3 may be reduced/minimized.

Except for the differences described above, other components and features of the image sensor according to the present embodiments may be substantially the same as corresponding components and features of the image sensor described with reference to FIGS. 3 to 5.

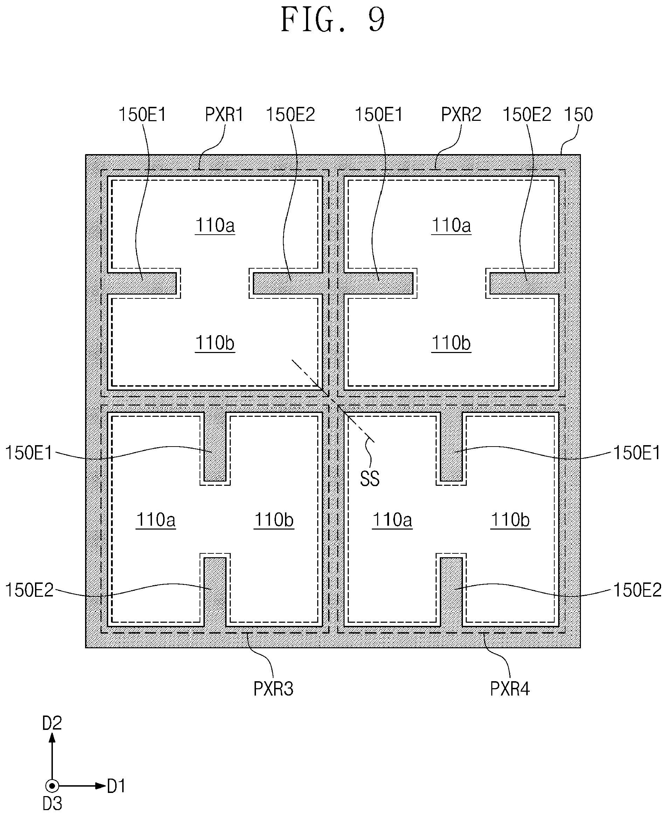

Referring to FIG. 9, according to some embodiments, the deep device isolation pattern 150 may include an extension 150E1 and 150E2 extending into each of the plurality of pixel regions PXR1, PXR2, PXR3 and PXR4 in the first direction D1 or the second direction D2. The extension 150E1 and 150E2 of the deep device isolation pattern 150 may include a first extension 150E1 and a second extension 150E2, which are spaced apart from each other in the first direction D1 or the second direction D2.

In each of the first and second pixel regions PXR1 and PXR2, the first extension 150E1 and the second extension 150E2 may be spaced apart from each other in the first direction D1. In each of the first and second pixel regions PXR1 and PXR2, the first extension 150E1 may extend from a portion of the deep device isolation pattern 150 into each of the first and second pixel regions PXR1 and PXR2 in the first direction D1, and the second extension 150E2 may extend from another portion of the deep device isolation pattern 150 into each of the first and second pixel regions PXR1 and PXR2 in an opposite direction to the first direction D1. In each of the first and second pixel regions PXR1 and PXR2, the first photoelectric conversion region 110a and the second photoelectric conversion region 110b may be adjacent to each other in the second direction D2 and may extend between the first and second extensions 150E1 and 150E2 so as to be connected to each other.

In each of the third and fourth pixel regions PXR3 and PXR4, the first extension 150E1 and the second extension 150E2 may be spaced apart from each other in the second direction D2. In each of the third and fourth pixel regions PXR3 and PXR4, the first extension 150E1 may extend from a portion of the deep device isolation pattern 150 into each of the third and fourth pixel regions PXR3 and PXR4 in an opposite direction to the second direction D2, and the second extension 150E2 may extend from another portion of the deep device isolation pattern 150 into each of the third and fourth pixel regions PXR3 and PXR4 in the second direction D2. In each of the third and fourth pixel regions PXR3 and PXR4, the first photoelectric conversion region 110a and the second photoelectric conversion region 110b may be adjacent to each other in the first direction D1 and may extend between the first and second extensions 150E1 and 150E2 so as to be connected to each other.

According to the present embodiments, the extensions 150E1 and 150E2 of the deep device isolation pattern 150 in the second pixel region PXR2 and the extensions 150E1 and 150E2 of the deep device isolation pattern 150 in the third pixel region PXR3 may be symmetrical with respect to the reference line SS. In this case, in the second and third pixel regions PXR2 and PXR3, overlapping areas of the electric fields F2 and F3 of FIG. 7 and the extensions 150E1 and 150E2 of the deep device isolation pattern 150 may be substantially equal to each other. Thus, a signal difference between the second pixel region PXR2 and the third pixel region PXR3 may be reduced/minimized.

Except for the differences described above, other components and features of the image sensor according to the present embodiments may be substantially the same as corresponding components and features of the image sensor described with reference to FIGS. 3 to 5.

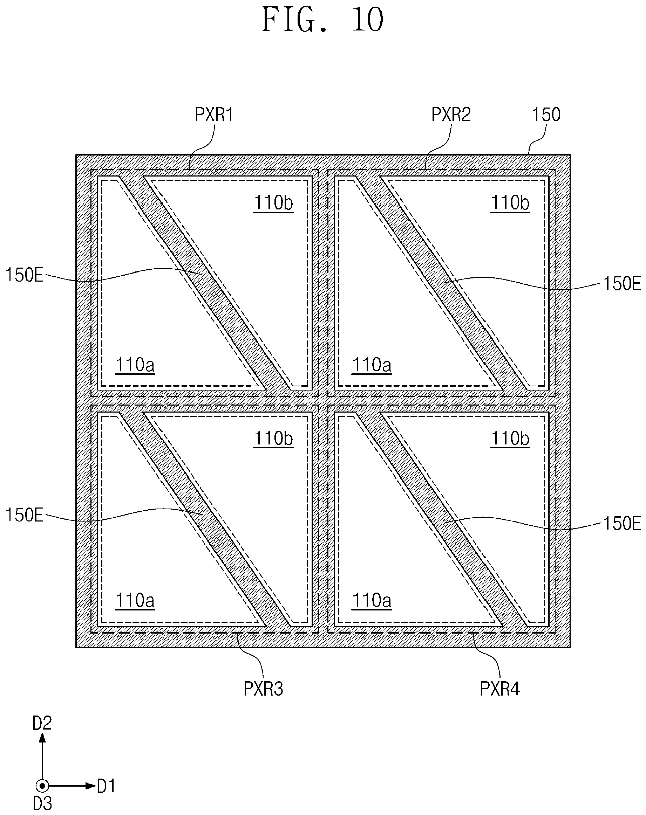

Referring to FIG. 10, according to some embodiments, the deep device isolation pattern 150 may include an extension 150E extending into each of the plurality of pixel regions PXR1, PXR2, PXR3 and PXR4. The extension 150E of the deep device isolation pattern 150 may extend into each of the plurality of pixel regions PXR1, PXR2, PXR3 and PXR4 in a direction (e.g., a diagonal direction) which is parallel to the first surface 100a of the substrate 100 and intersects the first direction D1 and the second direction D2 e.g. the extension 150E of the deep device isolation pattern 150 may extend into each of the plurality of pixel regions PXR1, PXR2, PXR3 and PXR4 in a direction (e.g., a diagonal direction) which is parallel to the first surface 100a of the substrate 100 and which extends along a direction between the first direction D1 and the second direction D2. For example, the extension 150E of the deep device isolation pattern 150 may intersect the inside of each of the plurality of pixel regions PXR1, PXR2, PXR3 and PXR4 in the diagonal direction. For example, the extension 150E of the deep device isolation pattern 150 may extend across each of the plurality of pixel regions PXR1, PXR2, PXR3 and PXR4 in the diagonal direction. The extension 150E may extend from a portion of the deep device isolation pattern 150 in the diagonal direction so as to be connected to another portion of the deep device isolation pattern 150.

In each of the plurality of pixel regions PXR1, PXR2, PXR3 and PXR4, the first photoelectric conversion region 110a and the second photoelectric conversion region 110b may be adj acent to each other in a direction which is parallel to the first surface 100a of the substrate 100 and which is perpendicular to the diagonal direction. The extension 150E of the deep device isolation pattern 150 may extend in the diagonal direction so as to be disposed between the first photoelectric conversion region 110a and the second photoelectric conversion region 110b and may completely isolate the first photoelectric conversion region 110a and the second photoelectric conversion region 110b from each other.

According to the present embodiments, the extension 150E of the deep device isolation pattern 150 in the second pixel region PXR2 and the extension 150E of the deep device isolation pattern 150 in the third pixel region PXR3 may be inclined along the diagonal direction in a plan view and may be symmetrical with respect to the origin. In this case, in the second and third pixel regions PXR2 and PXR3, overlapping areas of the electric fields F2 and F3 of FIG. 7 and the extensions 150E of the deep device isolation pattern 150 may be substantially equal to each other. Thus, a signal difference between the second pixel region PXR2 and the third pixel region PXR3 may be reduced/minimized.

Except for the differences described above, other components and features of the image sensor according to the present embodiments may be substantially the same as corresponding components and features of the image sensor described with reference to FIGS. 3 to 5.

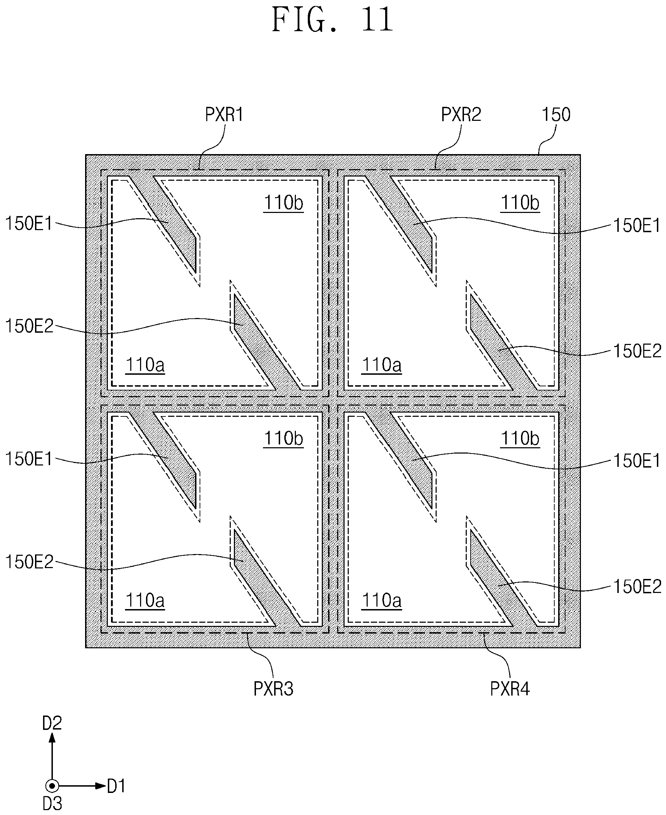

Referring to FIG. 11, according to some embodiments, the deep device isolation pattern 150 may include extensions 150E1 and 150E2 extending into each of the plurality of pixel regions PXR1, PXR2, PXR3 and PXR4 in the diagonal direction. The extensions 150E1 and 150E2 of the deep device isolation pattern 150 may include a first extension 150E1 and a second extension 150E2, which are spaced apart from each other in the diagonal direction.

In each of the plurality of pixel regions PXR1, PXR2, PXR3 and PXR4, the first extension 150E1 and the second extension 150E2 may be spaced apart from each other in the diagonal direction. The first extension 150E1 may extend from a portion of the deep device isolation pattern 150 into each of the plurality of pixel regions PXR1, PXR2, PXR3 and PXR4 in the diagonal direction, and the second extension 150E2 may extend from another portion of the deep device isolation pattern 150 into each of the plurality of pixel regions PXR1, PXR2, PXR3 and PXR4 in an opposite direction to the diagonal direction. In each of the plurality of pixel regions PXR1, PXR2, PXR3 and PXR4, the first photoelectric conversion region 110a and the second photoelectric conversion region 110b may be adjacent to each other in the direction perpendicular to the diagonal direction and may extend between the first and second extensions 150E1 and 150E2 so as to be connected to each other.

According to the present embodiments, the extensions 150E1 and 150E2 of the deep device isolation pattern 150 in the second pixel region PXR2 and the extensions 150E1 and 150E2 of the deep device isolation pattern 150 in the third pixel region PXR3 may be inclined along the diagonal direction in a plan view and may be symmetrical with respect to the origin. In this case, in the second and third pixel regions PXR2 and PXR3, overlapping areas of the electric fields F2 and F3 of FIG. 7 and the extensions 150E1 and 150E2 of the deep device isolation pattern 150 may be substantially equal to each other. Thus, a signal difference between the second pixel region PXR2 and the third pixel region PXR3 may be reduced/minimized.

Except for the differences described above, other components and features of the image sensor according to the present embodiments may be substantially the same as corresponding components and features of the image sensor described with reference to FIGS. 3 to 5.

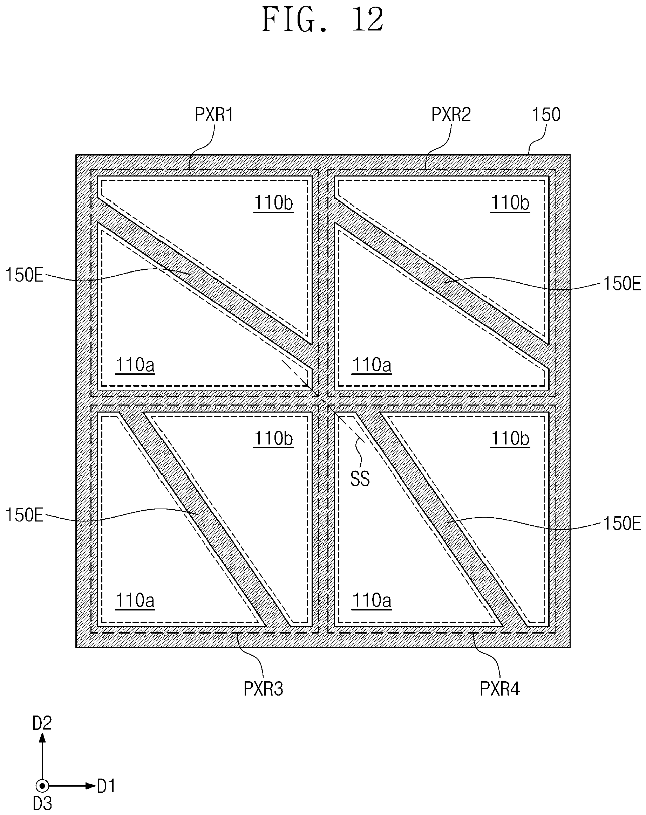

Referring to FIG. 12, according to some embodiments, the extension 150E of the deep device isolation pattern 150 may extend into each of the plurality of pixel regions PXR1, PXR2, PXR3 and PXR4 in a direction (e.g., the diagonal direction) which is parallel to the first surface 100a of the substrate 100 and intersects the first direction D1 and the second direction D2. For example, the extension 150E of the deep device isolation pattern 150 may extend into each of the plurality of pixel regions PXR1, PXR2, PXR3 and PXR4 in a direction (e.g., the diagonal direction) which is parallel to the first surface 100a of the substrate 100 and which extends along a direction between the first direction D1 and the second direction D2. The extension 150E may extend from a portion of the deep device isolation pattern 150 in the diagonal direction so as to be connected to another portion of the deep device isolation pattern 150.

According to the present embodiments, the extension 150E of the deep device isolation pattern 150 in the second pixel region PXR2 and the extension 150E of the deep device isolation pattern 150 in the third pixel region PXR3 may be inclined along the diagonal direction in a plan view and may be symmetrical with respect to the reference line SS. In this case, in the second and third pixel regions PXR2 and PXR3, overlapping areas of the electric fields F2 and F3 of FIG. 7 and the extensions 150E of the deep device isolation pattern 150 may be substantially equal to each other. Thus, a signal difference between the second pixel region PXR2 and the third pixel region PXR3 may be reduced/minimized. Except for the differences described above, other components and features of the image sensor according to the present embodiments may be substantially the same as corresponding components and features of the image sensor described with reference to FIG. 10.

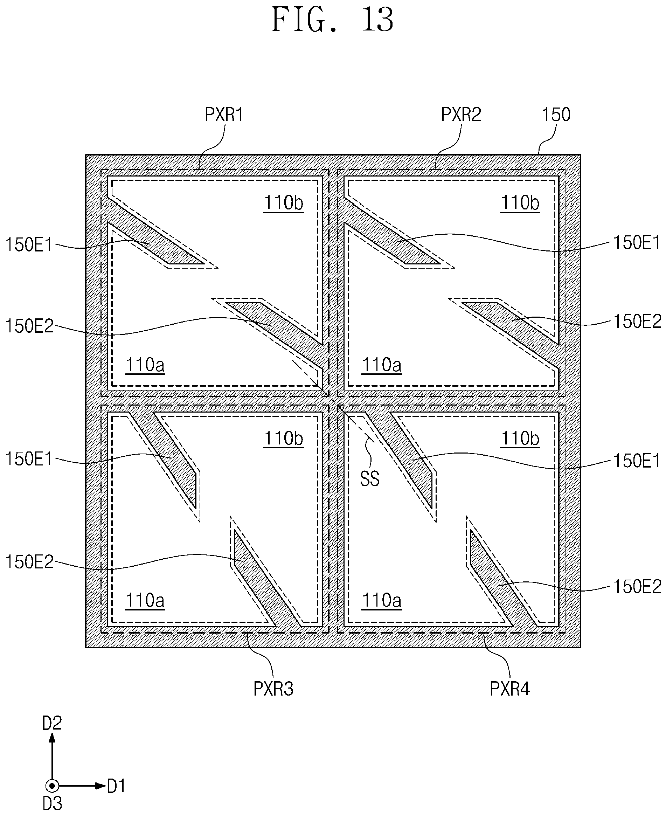

Referring to FIG. 13, according to some embodiments, the deep device isolation pattern 150 may include extensions 150E1 and 150E2 extending into each of the plurality of pixel regions PXR1, PXR2, PXR3 and PXR4 in the diagonal direction. The extensions 150E1 and 150E2 of the deep device isolation pattern 150 may include a first extension 150E1 and a second extension 150E2, which are spaced apart from each other in the diagonal direction. In each of the plurality of pixel regions PXR1, PXR2, PXR3 and PXR4, the first extension 150E1 and the second extension 150E2 may be spaced apart from each other in the diagonal direction.

According to the present embodiments, the extensions 150E1 and 150E2 of the deep device isolation pattern 150 in the second pixel region PXR2 and the extensions 150E1 and 150E2 of the deep device isolation pattern 150 in the third pixel region PXR3 may be inclined along the diagonal direction in a plan view and may be symmetrical with respect to the reference line SS. In this case, in the second and third pixel regions PXR2 and PXR3, overlapping areas of the electric fields F2 and F3 of FIG. 7 and the extensions 150E1 and 150E2 of the deep device isolation pattern 150 may be substantially equal to each other. Thus, a signal difference between the second pixel region PXR2 and the third pixel region PXR3 may be reduced/minimized. Except for the differences described above, other components and features of the image sensor according to the present embodiments may be substantially the same as corresponding components and features of the image sensor described with reference to FIG. 11.

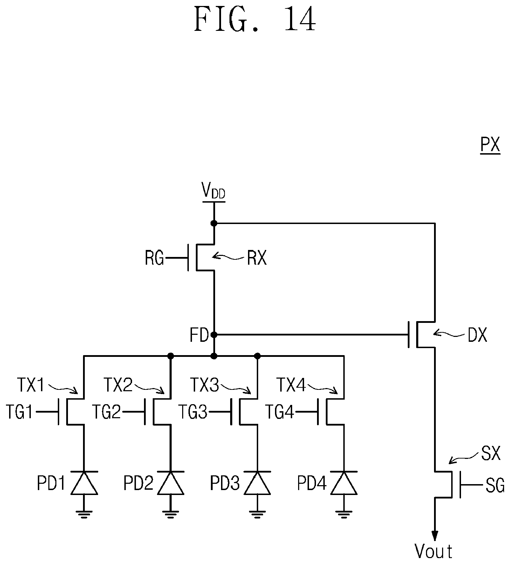

FIG. 14 is a circuit diagram illustrating a unit pixel of an image sensor according to some embodiments of the inventive concepts. Hereinafter, differences between the present embodiments and the above embodiments of FIG. 2 will be mainly described for the purpose of ease and convenience in explanation.

Referring to FIG. 14, each of the pixels PX may include first to fourth photoelectric conversion elements PD1, PD2, PD3 and PD4, first to fourth transfer transistors TX1, TX2, TX3 and TX4, and logic transistors RX, SX and DX. The first to fourth transfer transistors TX1, TX2, TX3 and TX4 may include first to fourth transfer gates TG1, TG2, TG3 and TG4, respectively.

The first to fourth photoelectric conversion elements PD1, PD2, PD3 and PD4 may generate and accumulate photocharges (or charges) in proportion to the amount of light incident from the outside and may be photodiodes, each of which includes a P-type dopant region and an N-type dopant region. The first transfer transistor TX1 may transfer charges generated from the first photoelectric conversion element PD1 to the floating diffusion region FD, and the second transfer transistor TX2 may transfer charges generated from the second photoelectric conversion element PD2 to the floating diffusion region FD. The third transfer transistor TX3 may transfer charges generated from the third photoelectric conversion element PD3 to the floating diffusion region FD, and the fourth transfer transistor TX4 may transfer charges generated from the fourth photoelectric conversion element PD4 to the floating diffusion region FD. The floating diffusion region FD may receive the charges generated from the first to fourth photoelectric conversion elements PD1, PD2, PD3 and PD4 and may cumulatively store the received charges.

Except for the differences described above, other components and features of the unit pixel PX according to the present embodiments may be substantially the same as corresponding components and features of the unit pixel PX of FIG. 2.

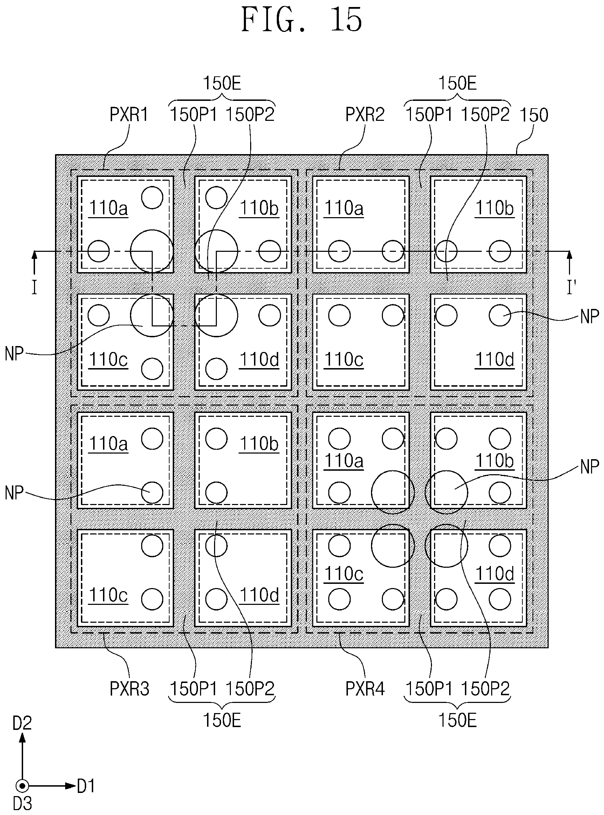

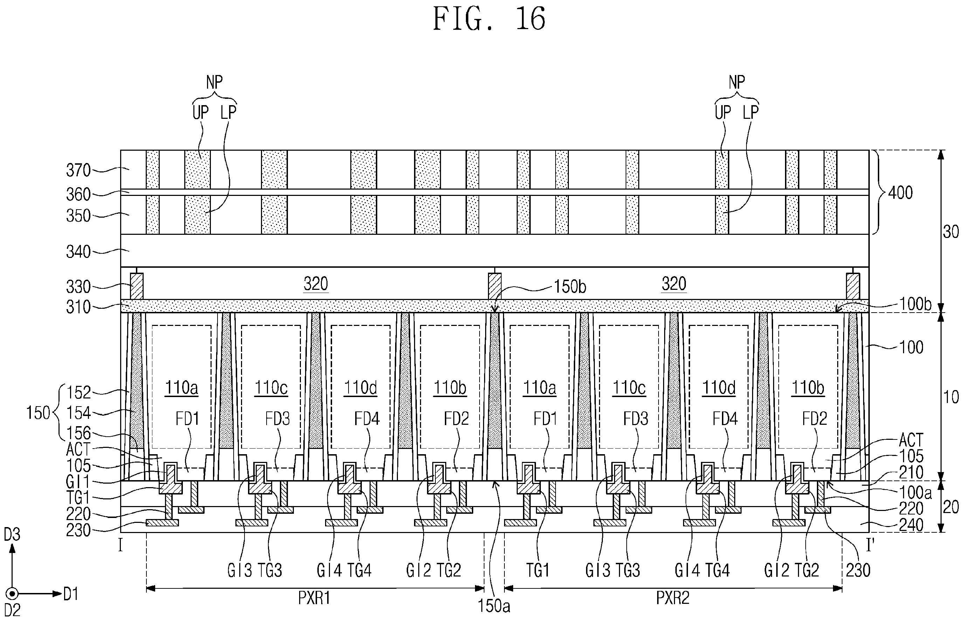

FIG. 15 is a plan view illustrating an image sensor according to some embodiments of the inventive concepts, and FIG. 16 is a cross-sectional view taken along a line I-I' of FIG. 15. Hereinafter, differences between the present embodiments and the above embodiments of FIGS. 3 to 5 will be mainly described for the purpose of ease and convenience in explanation.

Referring to FIGS. 15 and 16, according to some embodiments, the deep device isolation pattern 150 may include an extension 150E extending into each of the plurality of pixel regions PXR1, PXR2, PXR3 and PXR4 in the first direction D1 and the second direction D2. In each of the plurality of pixel regions PXR1, PXR2, PXR3 and PXR4, the extension 150E of the deep device isolation pattern 150 may include a first portion 150P1 extending in the second direction D2, and a second portion 150P2 extending in the first direction D1. The first portion 150P1 may extend from a portion of the deep device isolation pattern 150 in the second direction D2 so as to be connected to another portion of the deep device isolation pattern 150, and the second portion 150P2 may extend from a portion of the deep device isolation pattern 150 in the first direction D1 so as to be connected to another portion of the deep device isolation pattern 150.

A first photoelectric conversion region 110a, a second photoelectric conversion region 110b, a third photoelectric conversion region 110c and a fourth photoelectric conversion region 110d may be disposed in each of the plurality of pixel regions PXR1, PXR2, PXR3 and PXR4 and may be adjacent to each other in the first direction D1 and the second direction D2. The first photoelectric conversion region 110a and the second photoelectric conversion region 110b may be adjacent to each other in the first direction D1. The third photoelectric conversion region 110c may be adjacent to the first photoelectric conversion region 110a in the second direction D2, and the fourth photoelectric conversion region 110d may be adjacent to the second photoelectric conversion region 110b in the second direction D2. The third photoelectric conversion region 110c and the fourth photoelectric conversion region 110d may be adjacent to each other in the first direction D1.

The extension 150E of the deep device isolation pattern 150 may be disposed between the first to fourth photoelectric conversion regions 110a, 110b, 110c and 110d. The first portion 150P1 of the extension 150E may extend in the second direction D2 so as to be disposed between the first photoelectric conversion region 110a and the second photoelectric conversion region 110b and between the third photoelectric conversion region 110c and the fourth photoelectric conversion region 110d. The second portion 150P2 of the extension 150E may extend in the first direction D1 so as to be disposed between the first photoelectric conversion region 110a and the third photoelectric conversion region 110c and between the second photoelectric conversion region 110b and the fourth photoelectric conversion region 110d. In some embodiments, the extension 150E of the deep device isolation pattern 150 may completely isolate the first to fourth photoelectric conversion regions 110a, 110b, 110c and 110d from each other in each of the pixel regions PXR1, PXR2, PXR3 and PXR4.

The substrate 100 may have a first conductivity type, and the first to fourth photoelectric conversion regions 110a, 110b, 110c and 110d may be regions doped with dopants having a second conductivity type different from the first conductivity type. Each of the first to fourth photoelectric conversion regions 1 10a, 110b, 110c and 110d may form a PN junction with the substrate 100 to form a photodiode. For example, the first photoelectric conversion region 110a may form the PN junction with the substrate 100 to form a first photodiode (see PD1 of FIG. 14), and the second photoelectric conversion region 110b may form the PN junction with the substrate 100 to form a second photodiode (see PD2 of FIG. 14). The third photoelectric conversion region 110c may form the PN junction with the substrate 100 to form a third photodiode (see PD3 of FIG. 14), and the fourth photoelectric conversion region 110d may form the PN junction with the substrate 100 to form a fourth photodiode (see PD4 of FIG. 14). Each of the pixel regions PXR1, PXR2, PXR3 and PXR4 may correspond to the unit pixel (see PX of FIG. 14) including the first to fourth photodiodes (see PD1, PD2, PD3 and PD4 of FIG. 14).

A first transfer gate electrode TG1 and a first floating diffusion region FD1 may be disposed adjacent to the first surface 100a of the substrate 100 and may vertically overlap with the first photoelectric conversion region 110a (e.g., in the third direction D3). A second transfer gate electrode TG2 and a second floating diffusion region FD2 may be disposed adjacent to the first surface 100a of the substrate 100 and may vertically overlap with the second photoelectric conversion region 110b (e.g., in the third direction D3). A third transfer gate electrode TG3 and a third floating diffusion region FD3 may be disposed adjacent to the first surface 100a of the substrate 100 and may vertically overlap with the third photoelectric conversion region 110c (e.g., in the third direction D3). A fourth transfer gate electrode TG4 and a fourth floating diffusion region FD4 may be disposed adjacent to the first surface 100a of the substrate 100 and may vertically overlap with the fourth photoelectric conversion region 110d (e.g., in the third direction D3). The first transfer gate electrode TG1 and the first floating diffusion region FD1 may constitute the first transfer transistor TX1 of FIG. 14, and the second transfer gate electrode TG2 and the second floating diffusion region FD2 may constitute the second transfer transistor TX2 of FIG. 14. The third transfer gate electrode TG3 and the third floating diffusion region FD3 may constitute the third transfer transistor TX3 of FIG. 14, and the fourth transfer gate electrode TG4 and the fourth floating diffusion region FD4 may constitute the fourth transfer transistor TX4 of FIG. 14.

First to fourth gate dielectric patterns GI1, GI2, GI3 and GI4 may be disposed between the substrate 100 (i.e., the active pattern ACT) and the first to fourth transfer gate electrodes TG1, TG2, TG3 and TG4, respectively. The first interlayer insulating layer 210 may be disposed on the first surface 100a of the substrate 100 to cover the first to fourth transfer gate electrodes TG1, TG2, TG3 and TG4. The contact plugs 220 may penetrate the first interlayer insulating layer 210 so as to be electrically connected to the first to fourth transfer gate electrodes TG1, TG2, TG3 and TG4 and the first to fourth floating diffusion regions FD1, FD2, FD3 and FD4.

Each of the plurality of color filters 320 may vertically overlap with the first to fourth photoelectric conversion regions 110a, 110b, 110c and 110d of each of the plurality of pixel regions PXR1, PXR2, PXR3 and PXR4 (e.g., in the third direction D3).

Except for the differences described above, other components and features of the image sensor according to the present embodiments may be substantially the same as corresponding components and features of the image sensor described with reference to FIGS. 3 to 5.

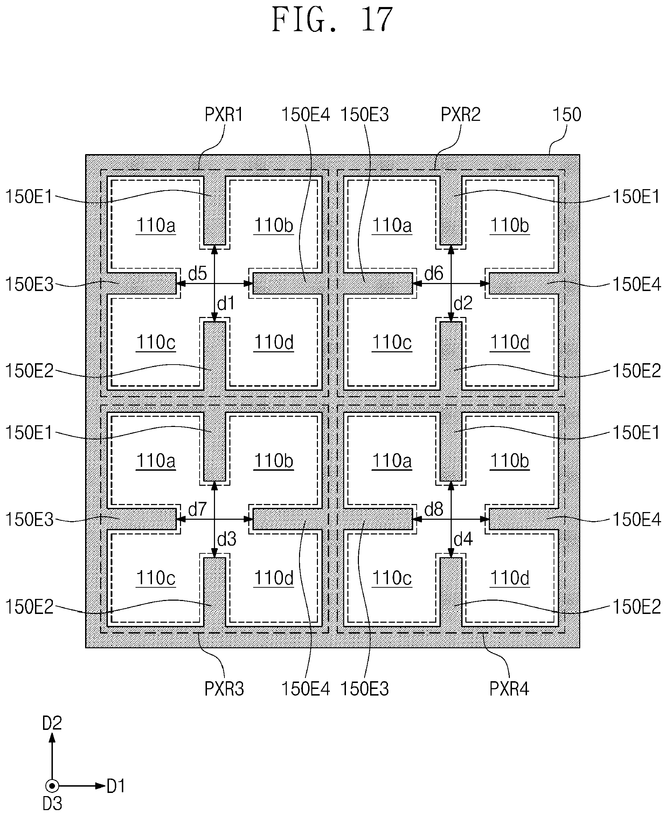

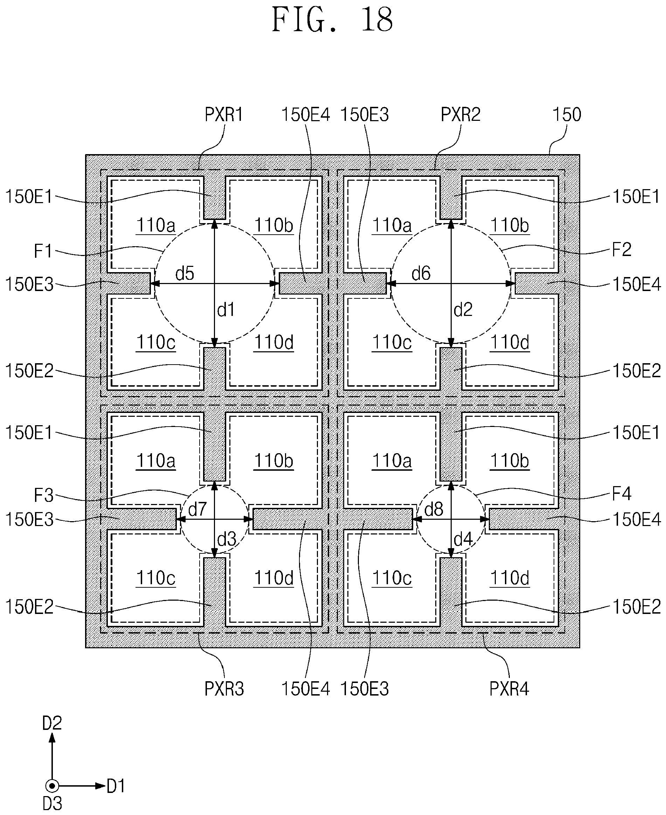

FIGS. 17 and 18 are plan views illustrating image sensors according to some embodiments of the inventive concepts. In FIGS. 17 and 18, the nano-posts NP of FIG. 15 are omitted for the purpose of ease and convenience in illustration. Hereinafter, differences between the present embodiments and the above embodiments of FIGS. 15 and 16 will be mainly described for the purpose of ease and convenience in explanation.

Referring to FIG. 17, according to some embodiments, the deep device isolation pattern 150 may include extensions 150E1, 150E2, 150E3 and 150E4 extending into each of the plurality of pixel regions PXR1, PXR2, PXR3 and PXR4 in the first direction D1 and the second direction D2. In each of the plurality of pixel regions PXR1, PXR2, PXR3 and PXR4, the extensions 150E1, 150E2, 150E3 and 150E4 of the deep device isolation pattern 150 may include a first extension 150E1 and a second extension 150E2 which are spaced apart from each other in the second direction D2, and a third extension 150E3 and a fourth extension 150E4 which are spaced apart from each other in the first direction D1. The first extension 150E1 may extend from a portion of the deep device isolation pattern 150 into each of the plurality of pixel regions PXR1, PXR2, PXR3 and PXR4 in an opposite direction to the second direction D2, and the second extension 150E2 may extend from another portion of the deep device isolation pattern 150 into each of the plurality of pixel regions PXR1, PXR2, PXR3 and PXR4 in the second direction D2. The third extension 150E3 may extend from a portion of the deep device isolation pattern 150 into each of the plurality of pixel regions PXR1, PXR2, PXR3 and PXR4 in the first direction D1, and the fourth extension 150E4 may extend from another portion of the deep device isolation pattern 150 into each of the plurality of pixel regions PXR1, PXR2, PXR3 and PXR4 in an opposite direction to the first direction D1.

In the first pixel region PXR1, the first extension 150E1 and the second extension 150E2 may be spaced apart from each other in the second direction D2 by a first distance d1, and the third extension 150E3 and the fourth extension 150E4 may be spaced apart from each other in the first direction D1 by a fifth distance d5. In the second pixel region PXR2, the first extension 150E1 and the second extension 150E2 may be spaced apart from each other in the second direction D2 by a second distance d2, and the third extension 150E3 and the fourth extension 150E4 may be spaced apart from each other in the first direction D1 by a sixth distance d6. In the third pixel region PXR3, the first extension 150E1 and the second extension 150E2 may be spaced apart from each other in the second direction D2 by a third distance d3, and the third extension 150E3 and the fourth extension 150E4 may be spaced apart from each other in the first direction D1 by a seventh distance d7. In the fourth pixel region PXR4, the first extension 150E1 and the second extension 150E2 may be spaced apart from each other in the second direction D2 by a fourth distance d4, and the third extension 150E3 and the fourth extension 150E4 may be spaced apart from each other in the first direction D1 by an eighth distance d8.

In some embodiments, the first to fourth distances d1, d2, d3 and d4 may be equal to each other. In certain embodiments, at least one of the first to fourth distances d1, d2, d3 and d4 may be different from the other(s) of the first to fourth distances d1, d2, d3 and d4. In some embodiments, the fifth to eighth distances d5, d6, d7 and d8 may be equal to each other. In certain embodiments, at least one of the fifth to eighth distances d5, d6, d7 and d8 may be different from the other(s) of the fifth to eighth distances d5, d6, d7 and d8.

The first to fourth photoelectric conversion regions 1 10a, 110b, 110c and 110d may be disposed in each of the plurality of pixel regions PXR1, PXR2, PXR3 and PXR4 and may be adjacent to each other in the first direction D1 and the second direction D2. In some embodiments, the first to fourth photoelectric conversion regions 110a, 110b, 110c and 110d may extend between the first to fourth extensions 150E1, 150E2, 150E3 and 150E4 of the deep device isolation pattern 150 so as to be connected to each other. In each of the plurality of pixel regions PXR1, PXR2, PXR3 and PXR4, the first extension 150E1 may be disposed between the first photoelectric conversion region 110a and the second photoelectric conversion region 110b, and the second extension 150E2 may be disposed between the third photoelectric conversion region 110c and the fourth photoelectric conversion region 110d. In each of the plurality of pixel regions PXR1, PXR2, PXR3 and PXR4, the third extension 150E3 may be disposed between the first photoelectric conversion region 110a and the third photoelectric conversion region 110c, and the fourth extension 150E4 may be disposed between the second photoelectric conversion region 110b and the fourth photoelectric conversion region 110d.

Except for the differences described above, other components and features of the image sensor according to the present embodiments may be substantially the same as corresponding components and features of the image sensor described with reference to FIGS. 15 and 16.

Referring to FIG. 18, according to some embodiments, distributions of electric fields F1, F2, F3 and F4 in a focal plane of the plurality of pixel regions PXR1, PXR2, PXR3 and PXR4 may be different from each other. In the plurality of pixel regions PXR1, PXR2, PXR3 and PXR4, the first to eighth distances d1, d2, d3, d4, d5, d6, d7 and d8 may be adjusted in such a way that overlapping areas of the electric fields F1, F2, F3 and F4 and the first to fourth extensions 150E1, 150E2, 150E3 and 150E4 of the deep device isolation pattern 150 are substantially equal to each other. For example, the first to fourth distances d1, d2, d3 and d4 may be different from each other, and the fifth to eighth distances d5, d6, d7 and d8 may be different from each other. In this case, a signal difference between the plurality of pixel regions PXR1, PXR2, PXR3 and PXR4 may be reduced/minimized. Except for the differences described above, other components and features of the image sensor according to the present embodiments may be substantially the same as corresponding components and features of the image sensor described with reference to FIG. 17.

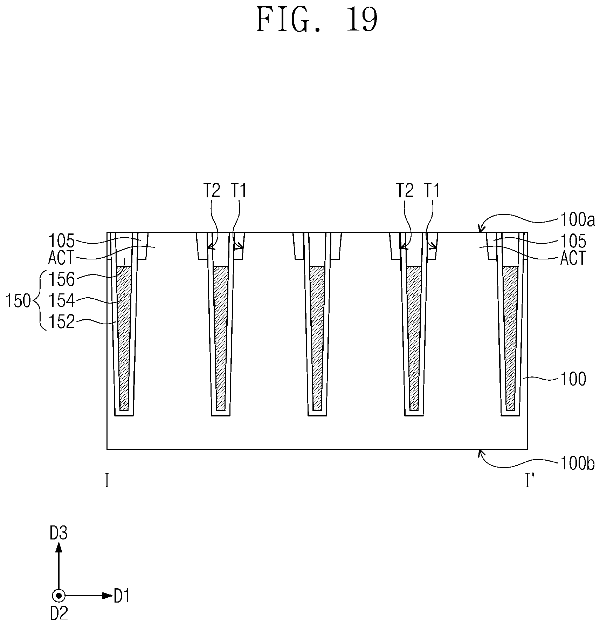

FIGS. 19 to 21 are cross-sectional views corresponding to the line I-I' of FIG. 3 to illustrate a method of manufacturing an image sensor according to some embodiments of the inventive concepts. Hereinafter, the descriptions of the same features as mentioned with reference to FIGS. 3 to 5 will be omitted for the purpose of ease and convenience in explanation.

Referring to FIGS. 3 and 19, a substrate 100 having first and second surfaces 100a and 100b opposite to each other may be provided. The substrate 100 may have a first conductivity type (e.g., a P-type). A first trench T1 may be formed adjacent to the first surface 100a of the substrate 100. The first trench T1 may define an active pattern ACT in the substrate 100. A shallow device isolation pattern 105 may be formed in the first trench T1. For example, the formation of the shallow device isolation pattern 105 may include forming a device isolation layer in (e.g., filling) the first trench T1 on the first surface 100a of the substrate 100, and planarizing the device isolation layer to expose the first surface 100a of the substrate 100.

A second trench T2 may be formed in the substrate 100. The second trench T2 may penetrate the shallow device isolation pattern 105 and may extend into the substrate 100. The second trench T2 may define a plurality of pixel regions PXR1, PXR2, PXR3 and PXR4 in the substrate 100. The plurality of pixel regions PXR1, PXR2, PXR3 and PXR4 may be arranged in the first direction D1 and the second direction D2. The second trench T2 may surround each of the plurality of pixel regions PXR1, PXR2, PXR3 and PXR4 when viewed in a plan view. The second trench T2 may extend in the first direction D1 and the second direction D2 to surround each of the plurality of pixel regions PXR1, PXR2, PXR3 and PXR4. Each of the plurality of pixel regions PXR1, PXR2, PXR3 and PXR4 may include the active pattern ACT defined by the first trench T1. The second trench T2 may extend into each of the plurality of pixel regions PXR1, PXR2, PXR3 and PXR4 in the second direction D2.

A deep device isolation pattern 150 may be formed in (e.g., to fill) the second trench T2. The deep device isolation pattern 150 may include a side insulating pattern 152 conformally covering an inner surface of the second trench T2, a semiconductor pattern 154 in (e.g., filling) a lower portion of the second trench T2, and a filling insulation pattern 156 in (e.g., filling) a remaining portion of the second trench T2 on the semiconductor pattern 154. In some embodiments, the side insulating pattern 152 may be a single layer including an insulating material (e.g., silicon oxide, silicon nitride, and/or silicon oxynitride). In certain embodiments, the side insulating pattern 152 may have a multi-layered structure including a first pattern 152A, a second pattern 152B and a third pattern 152C which are sequentially stacked between the substrate 100 and the semiconductor pattern 154, as described with reference to FIG. 5. In certain embodiments, unlike what is shown in FIG. 19, the deep device isolation pattern 150 may be a single pattern including an insulating material (e.g., silicon oxide, silicon nitride, and/or silicon oxynitride). The deep device isolation pattern 150 may include an extension 150E extending into each of the plurality of pixel regions PXR1, PXR2, PXR3 and PXR4 in the second direction D2.

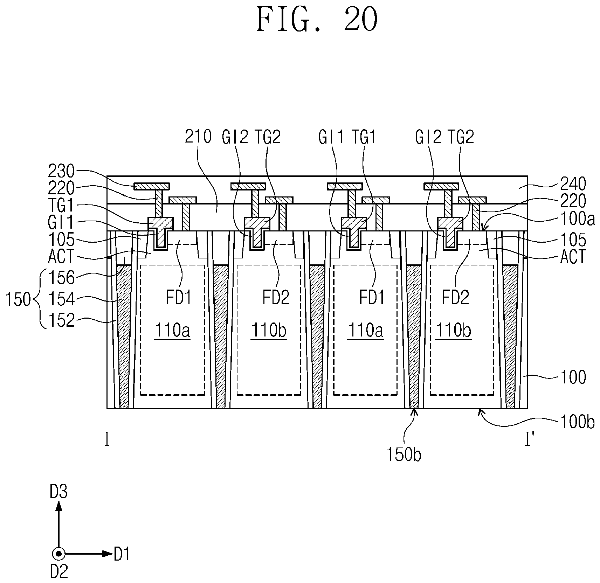

Referring to FIGS. 3 and 20, a first photoelectric conversion region 110a and a second photoelectric conversion region 110b may be formed in each of the plurality of pixel regions PXR1, PXR2, PXR3 and PXR4 and may be adjacent to each other in the first direction D1 in each of the pixel regions PXR1, PXR2, PXR3 and PXR4. The extension 150E of the deep device isolation pattern 150 may extend into each of the pixel regions PXR1, PXR2, PXR3 and PXR4 in the second direction D2 and may be disposed between the first photoelectric conversion region 110a and the second photoelectric conversion region 110b. For example, the formation of the first and second photoelectric conversion regions 110a and 110b may include injecting or implanting dopants having a second conductivity type (e.g., an N-type) different from the first conductivity type (e.g., the P-type) into the substrate 100.

A thinning process may be performed on the second surface 100b of the substrate 100, and portions of the substrate 100 and the deep device isolation pattern 150 may be removed by the thinning process. For example, the thinning process may include grinding or polishing the second surface 100b of the substrate 100, and/or anisotropically and/or isotropically etching the second surface 100b of the substrate 100. A lower portion of the deep device isolation pattern 150 may be removed by the thinning process, and a bottom surface 150b of the deep device isolation pattern 150 may be substantially coplanar with the second surface 100b of the substrate 100.

A first transfer gate electrode TG1, a first floating diffusion region FD1, a second transfer gate electrode TG2 and a second floating diffusion region FD2 may be formed on each of the pixel regions PXR1, PXR2, PXR3 and PXR4 and may be formed adjacent to the first surface 100a of the substrate 100. The first transfer gate electrode TG1 and the first floating diffusion region FD1 may be formed on a portion of the active pattern ACT and may vertically overlap with the first photoelectric conversion region 110a (e.g., in the third direction D3). The second transfer gate electrode TG2 and the second floating diffusion region FD2 may be formed on another portion of the active pattern ACT and may vertically overlap with the second photoelectric conversion region 110b (e.g., in the third direction D3). A first gate dielectric pattern GI1 may be formed between the first transfer gate electrode TG1 and the substrate 100 (i.e., the active pattern ACT), and a second gate dielectric pattern GI2 may be formed between the second transfer gate electrode TG2 and the substrate 100 (i.e., the active pattern ACT).

A first interlayer insulating layer 210 may be formed on the first surface 100a of the substrate 100 and may cover the first and second transfer gate electrodes TG1 and TG2 and the first and second floating diffusion regions FD1 and FD2. Some of contact plugs 220 may be formed in the first interlayer insulating layer 210 and may penetrate the first interlayer insulating layer 210 so as to be connected (e.g., electrically connected) to the first and second floating diffusion regions FD1 and FD2. A second interlayer insulating layer 240 may be formed on the first interlayer insulating layer 210. The others of the contact plugs 220 and conductive lines 230 may be formed in the second interlayer insulating layer 240. The others of the contact plugs 220 may penetrate the first interlayer insulating layer 210 and the second interlayer insulating layer 240 so as to be connected (e.g., electrically connected) to the first and second transfer gate electrodes TG1 and TG2. The conductive lines 230 may be connected (e.g., electrically connected) to the contact plugs 220.

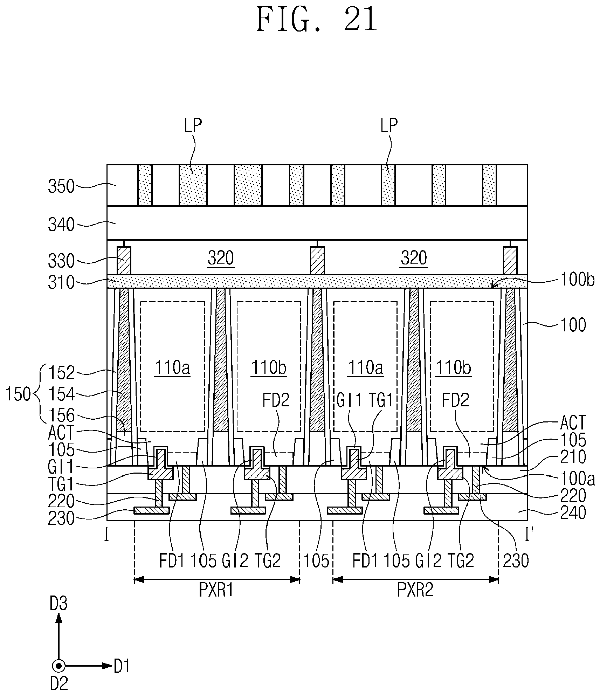

Referring to FIGS. 3 and 21, an anti-reflection layer 310 may be formed on the second surface 100b of the substrate 100, and a grid 330 and a color filter array 320 may be formed on the anti-reflection layer 310. The color filter array 320 may include a plurality of color filters 320, and the plurality of color filters 320 may be disposed on the plurality of pixel regions PXR1, PXR2, PXR3 and PXR4, respectively. Each of the plurality of color filters 320 may be formed to vertically overlap with the first and second photoelectric conversion regions 110a and 110b of each of the pixel regions PXR1, PXR2, PXR3 and PXR4 (e.g., in the third direction D3). The grid 330 may be disposed between the plurality of color filters 320.

A spacer layer 340 may be formed on the color filter array 320, and lower posts LP may be formed on the spacer layer 340. For example, the formation of the lower posts LP may include forming a lower layer on the spacer layer 340, and patterning the lower layer. The lower layer may include a material having a refractive index higher than that of the spacer layer 340. For example, the lower layer may include at least one of crystalline silicon, poly-silicon, amorphous silicon, a group III-V compound semiconductor material (e.g., GaP, GaN, GaAs, etc.), SiC, TiO₂, or SiN. A lower dielectric layer 350 may be formed on the spacer layer 340 and may be in (e.g., may fill) a space between the lower posts LP. The lower dielectric layer 350 may include a dielectric material having a refractive index lower than that of the lower posts LP.

Referring again to FIGS. 3 and 4, an etch stop layer 360 may be formed on the lower dielectric layer 350 and the lower posts LP and may cover the lower dielectric layer 350 and the lower posts LP. Upper posts UP may be formed on the etch stop layer 360. For example, the formation of the upper posts UP may include forming an upper layer on the etch stop layer 360, and patterning the upper layer. The upper layer may include a material having a refractive index higher than those of the spacer layer 340 and the lower dielectric layer 350. For example, the upper layer may include at least one of crystalline silicon, poly-silicon, amorphous silicon, a group III-V compound semiconductor material (e.g., GaP, GaN, GaAs, etc.), SiC, TiO₂, or SiN. The upper posts UP may be aligned with the lower posts LP, respectively, and may vertically overlap with the lower posts LP (e.g., in the third direction D3), respectively. An upper dielectric layer 370 may be formed on the etch stop layer 360 and may be in (e.g., may fill) a space between the upper posts UP. The upper dielectric layer 370 may include a dielectric material having a refractive index lower than that of the upper posts UP.

The lower posts LP and the upper posts UP may constitute nano-posts NP. The spacer layer 340, the nano-posts NP, the upper and lower dielectric layers 350 and 370 and the etch stop layer 360 may constitute a color separating lens array 400.

The image sensors described with reference to FIGS. 6 to 18 may be manufactured by substantially the same manufacturing method as described with reference to FIGS. 19 to 21.

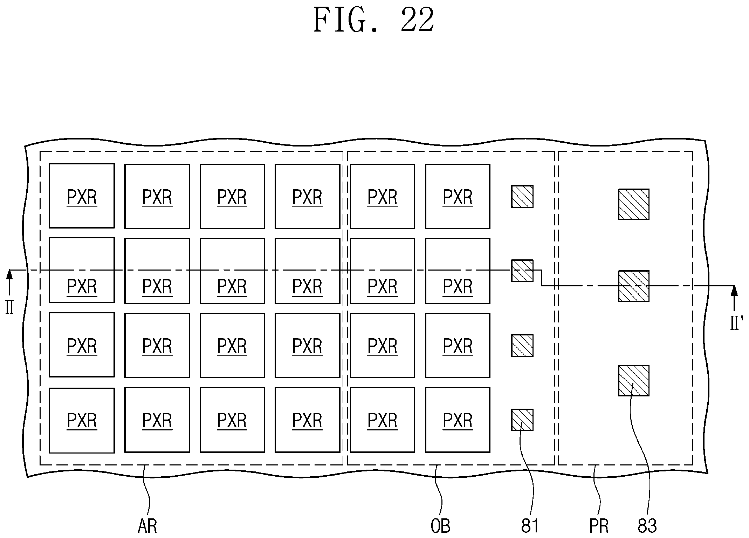

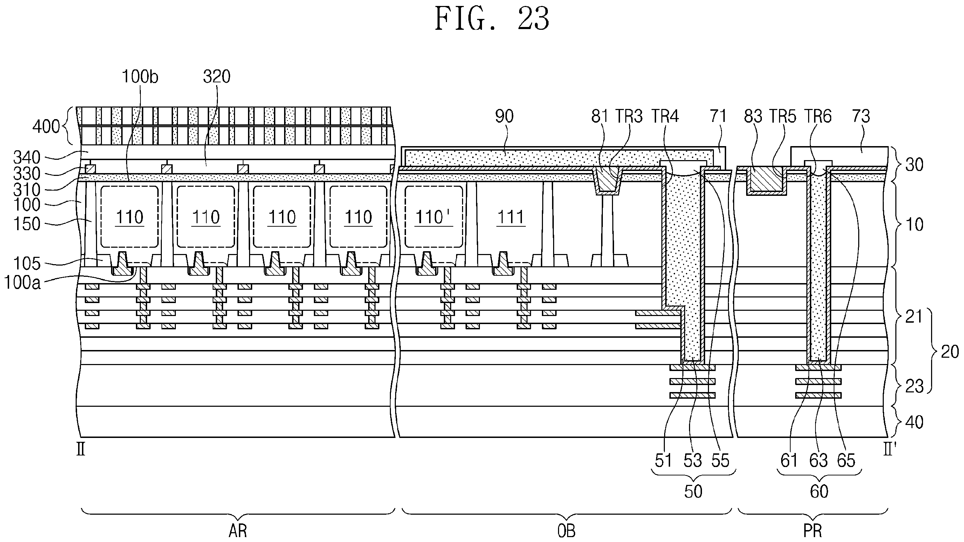

FIG. 22 is a plan view illustrating an image sensor according to some embodiments of the inventive concepts, and FIG. 23 is a cross-sectional view taken along a line II-II' of FIG. 22.

Referring to FIGS. 22 and 23, an image sensor may include a substrate 100 including a pixel array region AR, an optical black region OB and a pad region PR, an interconnection layer 20 on a first surface 100a of the substrate 100, a base substrate 40 on the interconnection layer 20, and a light transmitting layer 30 on a second surface 100b of the substrate 100. The interconnection layer 20 may be disposed between the first surface 100a of the substrate 100 and the base substrate 40. The interconnection layer 20 may include an upper interconnection layer 21 adjacent to the first surface 100a of the substrate 100, and a lower interconnection layer 23 between the upper interconnection layer 21 and the base substrate 40. The pixel array region AR may include a plurality of pixel regions PXR, and a deep device isolation pattern 150 disposed between the pixel regions PXR. The pixel array region AR may include substantially the same components as at least one of the image sensors described with reference to FIGS. 1 to 18.

A first connection structure 50, a first contact 81 and a bulk color filter 90 may be disposed on the optical black region OB of the substrate 100. The first connection structure 50 may include a first light blocking pattern 51, a first separation pattern 53, and a first capping pattern 55. The first light blocking pattern 51 may be disposed on the second surface 100b of the substrate 100. The first light blocking pattern 51 may cover the anti-reflection layer 310 and may conformally cover an inner surface of each of a third trench TR3 and a fourth trench TR4. The first light blocking pattern 51 may penetrate a photoelectric conversion layer 10 and the upper interconnection layer 21. The first light blocking pattern 51 may be electrically connected to the semiconductor pattern 154 of the deep device isolation pattern 150 of the photoelectric conversion layer 10 and may be connected to interconnection lines in the upper interconnection layer 21 and the lower interconnection layer 23. Thus, the first connection structure 50 may electrically connect the photoelectric conversion layer 10 and the interconnection layer 20. The first light blocking pattern 51 may include a metal material (e.g., tungsten). The first light blocking pattern 51 may block light incident on the optical black region OB.

The first contact 81 may be in (e.g., may fill) a remaining portion of the third trench TR3. The first contact 81 may include a metal material (e.g., aluminum). The first contact 81 may be electrically connected to the semiconductor pattern 154 of the deep device isolation pattern 150. A bias may be applied to the semiconductor pattern 154 through the first contact 81. The first separation pattern 53 may be in (e.g., may fill) a remaining portion of the fourth trench TR4. The first separation pattern 53 may penetrate the photoelectric conversion layer 10 and may penetrate a portion of the interconnection layer 20. The first separation pattern 53 may include an insulating material. The first capping pattern 55 may be disposed on the first separation pattern 53. The first capping pattern 55 may include the same material as the filling insulation pattern 156 of the deep device isolation pattern 150.

The bulk color filter 90 may be disposed on the first connection structure 50 and the first contact 81. The bulk color filter 90 may cover the first connection structure 50 and the first contact 81. A first protective layer 71 may be disposed on the bulk color filter 90 to seal or encapsulate the bulk color filter 90.

An additional photoelectric conversion region 110' and a dummy region 111 may be provided in corresponding pixel regions PXR of the optical black region OB. The additional photoelectric conversion region 110' may be a region doped with dopants (e.g., N-type dopants) having the second conductivity type different from the first conductivity type of the substrate 100. The additional photoelectric conversion region 110' may have a similar structure to that of photoelectric conversion regions 110 (e.g., the first and second photoelectric conversion regions 110a and 110b) in the plurality of pixel regions PXR of the pixel array region AR but may not perform the same operation (i.e., the operation of receiving light to generate an electrical signal) as the photoelectric conversion regions 110. The dummy region 111 may not be doped with dopants.

A second connection structure 60, a second contact 83 and a second protective layer 73 may be disposed on the pad region PR of the substrate 100. The second connection structure 60 may include a second light blocking pattern 61, a second separation pattern 63, and a second capping pattern 65.

The second light blocking pattern 61 may be disposed on the second surface 100b of the substrate 100. The second light blocking pattern 61 may cover the anti-reflection layer 310 and may conformally cover an inner surface of each of a fifth trench TR5 and a sixth trench TR6. The second light blocking pattern 61 may penetrate the photoelectric conversion layer 10 and the upper interconnection layer 21. The second light blocking pattern 61 may be connected to interconnection lines provided in the lower interconnection layer 23. Thus, the second connection structure 60 may electrically connect the photoelectric conversion layer 10 and the interconnection layer 20. The second light blocking pattern 61 may include a metal material (e.g., tungsten). The second light blocking pattern 61 may block light incident on the pad region PR.

The second contact 83 may be in (e.g., may fill) a remaining portion of the fifth trench TR5. The second contact 83 may include a metal material (e.g., aluminum). The second contact 83 may function as an electrical connection path between the image sensor and an external device. The second separation pattern 63 may be in (e.g., may fill) a remaining portion of the sixth trench TR6. The second separation pattern 63 may penetrate the photoelectric conversion layer 10 and may penetrate a portion of the interconnection layer 20. The second separation pattern 63 may include an insulating material. The second capping pattern 65 may be disposed on the second separation pattern 63. The second capping pattern 65 may include the same material as the filling insulation pattern 156 of the deep device isolation pattern 150. The second protective layer 73 may cover the second connection structure 60.

A current applied through the second contact 83 may flow to the semiconductor pattern 154 of the deep device isolation pattern 150 through the second light blocking pattern 61, the interconnection lines in the interconnection layer 20, and the first light blocking pattern 51. Electrical signals generated from the photoelectric conversion regions 110 (e.g., the first and second photoelectric conversion regions 110a and 110b) in the plurality of pixel regions PXR of the pixel array region AR may be transferred to the external device through the interconnection lines in the interconnection layer 20, the second light blocking pattern 61, and the second contact 83.

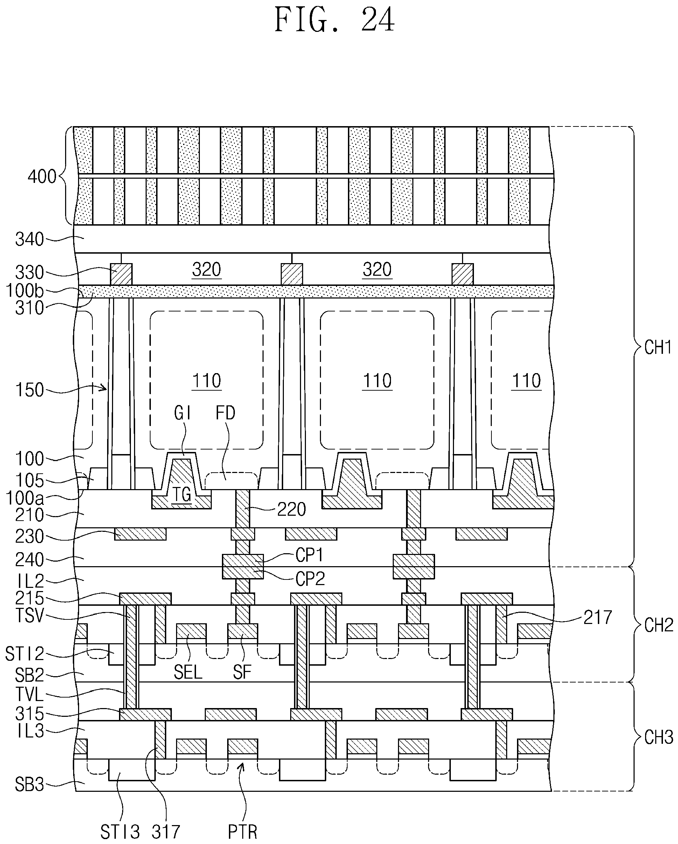

FIG. 24 is a cross-sectional view illustrating an image sensor according to some embodiments of the inventive concepts.

Referring to FIG. 24, according to some embodiments, an image sensor may have a structure in which first to third sub-chips CH1, CH2 and CH3 are sequentially stacked and are bonded to each other. The first sub-chip CH1 may perform an image sensing function. The first sub-chip CH1 may be substantially the same as one of the image sensors described with reference to FIGS. 1 to 18.

A first conductive pad CP1 may be disposed in the second interlayer insulating layer 240 of the first sub-chip CH1. The first conductive pad CP1 may be electrically connected to a corresponding one of the conductive lines 230 of the first sub-chip CH1 and may include, for example, copper.

The second sub-chip CH2 may include a second substrate SB2; selection gates SEL, source follower gates SF and reset gates (not shown), which are disposed on the second substrate SB2; and third interlayer insulating layers IL2 disposed on the second substrate SB2 and covering the selection gates SEL, the source follower gates SF and the reset gates. A second device isolation portion STI2 may be disposed in the second substrate SB2 to define active regions. Second contact plugs 217 and second interconnection lines 215 may be disposed in the third interlayer insulating layers IL2. A second conductive pad CP2 may be disposed in an uppermost one of the third interlayer insulating layers IL2 and may include, for example, copper. The second conductive pad CP2 may be in contact with the first conductive pad CP1. The source follower gates SF may be connected (e.g., electrically connected) to floating diffusion regions FD of the first sub-chip CH1, respectively.

The third sub-chip CH3 may include a third substrate SB3, peripheral transistors PTR on the third substrate SB3, and fourth interlayer insulating layers IL3 disposed on the third substrate SB3 and covering the peripheral transistors PTR. A third device isolation portion STI3 may be disposed in the third substrate SB3 to define active regions. Third contact plugs 317 and third interconnection lines 315 may be disposed in the fourth interlayer insulating layers IL3. An uppermost one of the fourth interlayer insulating layers IL3 may be in contact with the second substrate SB2. A through-electrode TSV may penetrate the third interlayer insulating layer IL2, the second device isolation portion STI2, the second substrate SB2 and the fourth interlayer insulating layer IL3 to electrically connect the second interconnection line 215 and the third interconnection line 315. A side surface of the through-electrode TSV may be surrounded by a via insulating layer TVL. The third sub-chip CH3 may include circuits for driving the first and/or second sub-chips CH1 and/or CH2 and/or for storing electrical signals generated from the first and/or second sub-chips CH1 and/or CH2.

Various features described herein are discussed in relation to "horizontal" or "vertical" directions. It will be appreciated that these directions are directions relative to the image sensor (e.g. relative to the first surface of the substrate), and do not imply any particular orientation of the image sensor in use. For instance, a horizontal direction may be a direction parallel to the first surface, and a vertical direction may be a direction perpendicular to the first surface.

According to the inventive concepts, the image sensor may include the color separating lens array, and the color separating lens array may be configured to separate wavelengths of incident light and may be configured to allow lights having different wavelengths to be irradiated to different pixel regions. Thus, the light efficiency of the incident light may be increased/maximized, and the sensitivity of the pixel regions may be improved. In addition, the image sensor may further include the deep device isolation pattern disposed between the pixel regions. Thus, the cross-talk between the pixel regions may be inhibited/minimized.

Moreover, the deep device isolation pattern may include the extension extending into each of the pixel regions, and the extension of the deep device isolation pattern may be disposed between the first photoelectric conversion region and the second photoelectric conversion region in each of the pixel regions. Accordingly, it is possible to inhibit/minimize interference between lights incident on the first photoelectric conversion region and the second photoelectric conversion region in each of the pixel regions, and thus each of the pixel regions may function as an auto-focus pixel.

As a result, it is possible to provide an image sensor which enables an auto-focus function and which is capable of improving the sensitivity of the pixel and of inhibiting/minimizing the cross-talk between the pixels.

While the embodiments of the inventive concepts have been particularly shown and described, it will be understood by one of ordinary skill in the art that variations in form and detail may be made therein without departing from the scope of the attached claims.

## Claims

1. An image sensor comprising:
a substrate having a first surface and a second surface which are opposite to each other, the substrate comprising a plurality of pixel regions arranged in a first direction and a second direction which are parallel to the first surface and intersect each other;
a deep device isolation pattern extending into the substrate and between the plurality of pixel regions; and
a color separating array on the second surface of the substrate,
wherein the color separating array comprises:
a spacer layer on the second surface of the substrate; and
a plurality of nano-posts horizontally spaced apart from each other on the spacer layer.

2. The image sensor of claim 1, wherein the plurality of nano-posts includes a material having a refractive index higher than that of the spacer layer.

3. The image sensor of claim 1 or 2, wherein the color separating array further comprises:
a dielectric layer on the spacer layer and in a space between the plurality of nano-posts, and
wherein the plurality of nano-posts includes a material having a refractive index higher than those of the dielectric layer and the spacer layer.

4. The image sensor of any preceding claim, wherein the deep device isolation pattern extends into the substrate in a third direction perpendicular to the first surface of the substrate, and
wherein the color separating array vertically overlaps with the substrate and the deep device isolation pattern in the third direction.

5. The image sensor of claim 4, wherein the deep device isolation pattern has a third surface and a fourth surface which are opposite to each other in the third direction, and
wherein the first surface of the substrate is coplanar with the third surface of the deep device isolation pattern, and the second surface of the substrate is coplanar with the fourth surface of the deep device isolation pattern.

6. The image sensor of any preceding claim, wherein each of the plurality of pixel regions comprises: a first photoelectric conversion region and a second photoelectric conversion region which are adjacent to each other in a direction parallel to the first surface of the substrate, and
wherein the deep device isolation pattern comprises an extension extending into each of the plurality of pixel regions between the first photoelectric conversion region and the second photoelectric conversion region.

7. The image sensor of claim 6, wherein the extension of the deep device isolation pattern completely isolates the first photoelectric conversion region and the second photoelectric conversion region from each other.

8. The image sensor of claim 6 or 7, wherein the deep device isolation pattern extends in the first direction and the second direction to surround each of the plurality of pixel regions, when viewed in a plan view.

9. The image sensor of claim 8, wherein the extension of the deep device isolation pattern extends in the second direction from a portion of the deep device isolation pattern to be connected to another portion of the deep device isolation pattern and completely isolates the first photoelectric conversion region and the second photoelectric conversion region from each other.

10. The image sensor of claim 8, wherein the extension of the deep device isolation pattern comprises: a first extension and a second extension which are spaced apart from each other in the second direction, and
wherein the first extension and the second extension are between the first photoelectric conversion region and the second photoelectric conversion region.

11. The image sensor of claim 10, wherein a distance, in the second direction, between the first extension and the second extension in one of the plurality of pixel regions is different from a distance, in the second direction, between the first extension and the second extension in another of the plurality of pixel regions.

12. The image sensor of claim 8, wherein each of the plurality of pixel regions further comprises: a third photoelectric conversion region and a fourth photoelectric conversion region which are adjacent to each other in the first direction,
wherein the third photoelectric conversion region and the fourth photoelectric conversion region are adjacent to the first photoelectric conversion region and the second photoelectric conversion region in the second direction, respectively, and
wherein the extension of the deep device isolation pattern comprises:
a first portion extending into each of the plurality of pixel regions in the second direction between the first photoelectric conversion region and the second photoelectric conversion region and between the third photoelectric conversion region and the fourth photoelectric conversion region; and
a second portion extending into each of the plurality of pixel regions in the first direction between the first photoelectric conversion region and the third photoelectric conversion region and between the second photoelectric conversion region and the fourth photoelectric conversion region.

13. The image sensor of claim 8, wherein each of the plurality of pixel regions further comprises: a third photoelectric conversion region and a fourth photoelectric conversion region which are adjacent to each other in the first direction,
wherein the third photoelectric conversion region and the fourth photoelectric conversion region are adjacent to the first photoelectric conversion region and the second photoelectric conversion region in the second direction, respectively,
wherein the extension of the deep device isolation pattern comprises:
a first extension and a second extension which are spaced apart from each other in the second direction in each of the plurality of pixel regions; and
a third extension and a fourth extension which are spaced apart from each other in the first direction in each of the plurality of pixel regions,
wherein the first extension is between the first photoelectric conversion region and the second photoelectric conversion region, and the second extension is between the third photoelectric conversion region and the fourth photoelectric conversion region, and
wherein the third extension is between the first photoelectric conversion region and the third photoelectric conversion region, and the fourth extension is between the second photoelectric conversion region and the fourth photoelectric conversion region.

14. The image sensor of claim 13, wherein a distance, in the second direction, between the first extension and the second extension in one of the plurality of pixel regions is different from a distance, in the second direction, between the first extension and the second extension in another of the plurality of pixel regions.
